(19) Europäisches Patentamt
European Patent Office
Office européen des brevets

(11) **EP 4 205 902 A1**

(12) **EUROPEAN PATENT APPLICATION**
published in accordance with Art. 153(4) EPC

(43) Date of publication:
**05.07.2023 Bulletin 2023/27**

(21) Application number: **21861699.3**

(22) Date of filing: **27.08.2021**

(51) International Patent Classification (IPC):
***B24B 7/04*** *(2006.01)* ***B23Q 3/08*** *(2006.01)*
***B24B 37/04*** *(2012.01)* ***B24B 41/06*** *(2012.01)*
***H01L 21/304*** *(2006.01)*

(52) Cooperative Patent Classification (CPC):
**B23Q 3/08; B24B 7/04; B24B 37/04; B24B 41/06; H01L 21/304**

(86) International application number:
**PCT/JP2021/031454**

(87) International publication number:
**WO 2022/045278 (03.03.2022 Gazette 2022/09)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.08.2020 JP 2020143675**

(71) Applicant: **FUJIFILM Corporation**
**Tokyo 106-8620 (JP)**

(72) Inventor: **SAIE, Toshiyuki**
**Haibara-gun, Shizuoka 421-0396 (JP)**

(74) Representative: **HGF**
**HGF Limited**
**1 City Walk**
**Leeds LS11 9DX (GB)**

(54) **METHOD FOR MANUFACTURING PROCESSED SUBSTRATE, METHOD FOR MANUFACTURING SEMICONDUCTOR ELEMENT, AND COMPOSITION FOR FORMING TEMPORARY ADHESIVE LAYER**

(57) Provided are a manufacturing method of a processed base material, including a step of forming a temporary adhesive layer on a surface of one member of a base material or a support, a step of flattening a surface of the temporary adhesive layer on a side opposite to a surface in contact with the base material or a surface of the temporary adhesive layer on a side opposite to a surface in contact with the support by at least one unit of polishing or grinding, a step of contacting the flattened surface with a member of the base material or the support, on which the temporary adhesive layer has not been formed, and a step of processing a surface of the base material on a side opposite to a surface in contact with the temporary adhesive layer, in which the temporary adhesive layer contains an inorganic filler; a manufacturing method of a semiconductor element, including the manufacturing method of a processed base material; and a composition for forming a temporary adhesive layer, in which workability of a base material is excellent.

FIG. 1A

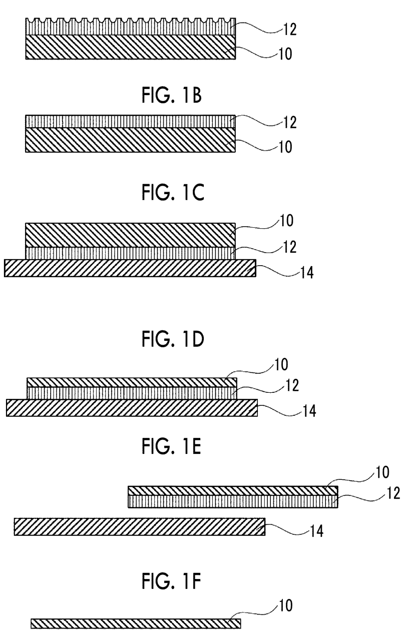


EP 4 205 902 A1

## Description

## BACKGROUND OF THE INVENTION

### 1. Field of the Invention

The present invention relates to a manufacturing method of a processed base material, a manufacturing method of a semiconductor element, and a composition for forming a temporary adhesive layer.

### 2. Description of the Related Art

In a manufacturing step of a semiconductor element (semiconductor process), in a case of processing a base material, the base material is processed after manufacturing a laminate including a support, a temporary adhesive layer, and the base material in this order. In the manufacturing of the above-described laminate, a method of forming the temporary adhesive layer on one of the base material and the support and contacting the other of the base material and the support with the temporary adhesive layer is used.

For example, JP2017-103441A discloses a method for flattening a device silicon substrate with a bump, which goes through the following steps.

(1) an adhesive layer is provided on a bump surface of the device silicon substrate with a bump.
(2) the device silicon substrate with a bump is fixed to a vacuum chuck of a grinding machine such that the adhesive layer is the upper surface and the silicon substrate surface is the lower surface.
(3) the adhesive layer of the above-described device silicon substrate fixed to the vacuum chuck is subjected to down-feed grinding by a cup wheel type grinding wheel to grind and remove the adhesive layer to a thickness in which the surface of the adhesive layer covers the bump. In this case, high-pressure water at a pressure of 5 to 12 MPa is jetted from a jetting nozzle with an opening angle of 4 to 15 degrees to a cutting edge portion of the cup wheel type grinding wheel, which is not used for grinding the adhesive layer of the device silicon substrate, so that adhesive residues adhering to the cutting edge are washed away and drained out of the grinding operation stage.
(4) next, device silicon substrate with a bump is fixed to a substrate vacuum chuck of the grinding machine such that the adhesive layer is the lower surface and the silicon substrate surface is the upper surface.
(5) while supplying a grinding aqueous solution to the silicon substrate surface, the silicon substrate surface is subjected to down-feed grinding by a cup wheel type grinding wheel to grind and remove the silicon substrate surface to a thickness of 30 to 100 $\mu$m.

In addition, JP2012-174956A discloses a manufacturing method of a semiconductor device, including (a) a step of applying a resin member onto a first main surface of a semiconductor wafer having a step structure on the first main surface, (b) a step of flattening a surface of the resin member by heating the resin member, in which the resin member is formed also on a side surface of the semiconductor wafer, (c) a step of performing a thinning process for the semiconductor wafer on a second main surface of the semiconductor wafer after the step (b), and (d) a step of removing the resin member from the semiconductor wafer after the step (c).

## SUMMARY OF THE INVENTION

Here, in a case where the temporary adhesive layer is formed on the base material or the support having the step, the temporary adhesive layer itself may have a step.

In order to improve workability of the subsequent base material, the temporary adhesive layer having such a step is subjected to polishing and grinding, and the surface thereof may be flattened.

However, in a case where the above-mentioned flattening is performed by using a temporary adhesive layer in the related art, devices, equipment, and the like (for example, diamond blade) used for the polishing or the grinding are clogged, and it is difficult to flatten the surface. As a result, the workability of the base material may be reduced, such as breakage in the base material in a case of processing the base material.

An object of the present invention is to provide a manufacturing method of a processed base material, in which workability of a base material is excellent, a manufacturing method of a semiconductor element, which includes the manufacturing method of a processed base material, and a composition for forming a temporary adhesive layer, in which workability of a base material is excellent.

Examples of typical aspects of the present invention are shown below.

<1> A manufacturing method of a processed base material, comprising:

a step of forming a temporary adhesive layer by applying a composition for forming a temporary adhesive layer onto a surface of one member of a base material or a support;
a step of flattening a surface of the temporary adhesive layer on a side opposite to a surface in contact with the base material or a surface of the temporary adhesive layer on a side opposite to a surface in contact with the support by at least one unit of polishing or grinding;
a step of contacting the flattened surface of the temporary adhesive layer after the flattening with a member of the base material or the support, on which the temporary adhesive layer has not been formed; and
a step of processing a surface of the base material on a side opposite to a surface in contact with the temporary adhesive layer,
in which the temporary adhesive layer contains an inorganic filler.

<2> The manufacturing method of a processed base material according to <1>,
in which the inorganic filler includes silica or alumina.
<3> The manufacturing method of a processed base material according to <1> or <2>,
in which a content of the inorganic filler is 20% by volume or more with respect to a total volume of the temporary adhesive layer.
<4> The manufacturing method of a processed base material according to any one of <1> to <3>,
in which, in the step of forming the temporary adhesive layer, the surface to which the composition for forming a temporary adhesive layer is applied has an unevenness with a height difference of 1 μm or more.
<5> The manufacturing method of a processed base material according to any one of <1> to <4>,
in which, in the step of forming the temporary adhesive layer, a method for applying the composition for forming a temporary adhesive layer is any one of spin coating, slit coating, or spiral coating.
<6> The manufacturing method of a processed base material according to any one of <1> to <5>,
in which the step of forming the temporary adhesive layer is a step of forming the temporary adhesive layer by drying the composition for forming a temporary adhesive layer while changing a temperature by 30°C or higher, after applying the composition for forming a temporary adhesive layer.
<7> The manufacturing method of a processed base material according to any one of <1> to <6>, further comprising:
a step of peeling off the base material and the support after the processing step.
<8> The manufacturing method of a processed base material according to <7>,
in which the peeling step is a step of peeling off the base material and the support at an interface between the support and the temporary adhesive layer.
<9> The manufacturing method of a processed base material according to any one of <1> to <8>, further comprising:
a step of removing the temporary adhesive layer from the base material by spray washing.
<10> The manufacturing method of a processed base material according to any one of <1> to <9>,
in which the support is in a form of a sheet or a film.
<11> A manufacturing method of a semiconductor element, comprising:
the manufacturing method of a processed base material according to any one of <1> to <10>.
<12> A composition for forming a temporary adhesive layer, which is used for forming the temporary adhesive layer according to any one of <1> to <10>.

An object of the present invention is to provide a manufacturing method of a processed base material, in which workability of a base material is excellent, a manufacturing method of a semiconductor element, which includes the manufacturing method of a processed base material, and a composition for forming a temporary adhesive layer, in which workability of a base material is excellent.

## BRIEF DESCRIPTION OF THE DRAWINGS

Figs. 1A to 1F are schematic cross-sectional diagrams showing an example of a manufacturing method of a processed base material according to the embodiment of the present invention.

## DESCRIPTION OF THE PREFERRED EMBODIMENTS

Hereinafter, main embodiments of the present invention will be described. However, the present invention is not limited to the specified embodiments.
In the present specification, a numerical range expressed using the term "to" means a range which includes the preceding and succeeding numerical values of "to" as a lower limit value and an upper limit value, respectively.
In the present specification, the term "step" is meant to include not only an independent step, but also a step which cannot be clearly distinguished from other steps as long as an intended action of the step is achieved.

In the present specification, with regard to a group (atomic group), in a case where the group (atomic group) is described without specifying whether the group (atomic group) is substituted or unsubstituted, the description means that the group (atomic group) includes both a group (atomic group) having no substituent and a group having a substituent. For example, in a case where a group is simply described as an "alkyl group", the description means that the alkyl group includes both an alkyl group having no substituent (unsubstituted alkyl group) and an alkyl group having a substituent (substituted alkyl group).

In the present specification, unless otherwise specified, "exposure" is meant to include not only drawing using light but also drawing using particle rays such as electron beams and ion beams. Examples of energy rays used for the drawing include actinic rays such as a bright line spectrum of a mercury lamp, far ultraviolet rays typified by an excimer laser, extreme ultraviolet rays (EUV light), and X-rays, and particle rays such as electron beams and ion beams.

In the present specification, "(meth)acrylate" means both "acrylate" and "methacrylate" or either of them, "(meth)acryl" means both "acryl" and "methacryl" or either of them, and "(meth)acryloyl" means both "acryloyl" and "methacryloyl" or either of them.

In the present specification, a solid content in a composition means components other than a solvent, and a content (concentration) of the solid content in the composition is represented by the mass percentage of the components other than the solvent with respect to the total mass of the composition, unless otherwise specified.

In the present specification, a temperature is 23°C and an atmospheric pressure is 101,325 Pa (1 atm), unless otherwise specified.

In the present specification, a weight-average molecular weight (Mw) and a number-average molecular weight (Mn) are each expressed as a value in terms of polystyrene according to gel permeation chromatography (GPC measurement), unless otherwise specified. The weight-average molecular weight (Mw) and the number-average molecular weight (Mn) can be determined, for example, by using HLC-8220 (manufactured by TOSOH CORPORATION), and, as columns, GUARD COLUMN HZ-L, TSKgel Super HZM-M, TSKgel Super HZ4000, TSKgel Super HZ3000, and TSKgel Super HZ2000 (manufactured by TOSOH CORPORATION). In addition, the measurement is performed using tetrahydrofuran (THF) as an eluent, unless otherwise specified. Furthermore, for the detection in the GPC measurement, a detector of ultraviolet rays (UV rays) having a wavelength of 254 nm is used, unless otherwise specified.

In the present specification, regarding a positional relationship of respective layers constituting a laminate, in a case where there is a description of "upper" or "lower", another layer may be on an upper side or a lower side of a reference layer among a plurality of layers of interest. That is, a third layer or element may be further interposed between the reference layer and the other layer, and the reference layer and the other layer are not necessary to be in contact with each other. In addition, unless otherwise specified, in a case where a direction in which layers are stacked on a base material is referred to as "upward" or there is a photosensitive layer, a direction from the base material to the photosensitive layer is referred to as "upward", and the opposite direction is referred to as "downward". Furthermore, such setting of upward and downward directions is for convenience in the present specification, and in a practical aspect, the "upward" direction in the present specification may be different from a vertically upward direction.

Hereinafter, embodiments of the laminate according to the present invention will be described with reference to the drawings, the present invention is not limited thereto. For easy visual recognition, the scale of each component in the drawings is appropriately different from the actual scale.

(Manufacturing method of processed base material)

The manufacturing method of a processed base material according to the embodiment of the present invention is a manufacturing method of a processed base material, including: a step of forming a temporary adhesive layer by applying a composition for forming a temporary adhesive layer onto a surface of one member of a base material or a support; a step of flattening a surface of the temporary adhesive layer on a side opposite to a surface in contact with the base material or a surface of the temporary adhesive layer on a side opposite to a surface in contact with the support by at least one unit of polishing or grinding; a step of contacting the flattened surface of the temporary adhesive layer after the flattening with a member of the base material or the support, on which the temporary adhesive layer has not been formed; and a step of processing a surface of the base material on a side opposite to a surface in contact with the temporary adhesive layer, in which the temporary adhesive layer contains an inorganic filler.

The manufacturing method of a processed base material is excellent in workability of the base material.

The mechanism for obtaining the above-described effects is not clear, but is presumed as follows.

As described above, in a case where the temporary adhesive layer has a step, when processing (for example, thinning) the base material in a laminate including the support, the temporary adhesive layer, and the base material in this order, workability of the base material may be reduced, such as breakage in the base material. Here, the thinning means reducing a thickness of the base material.

It is presumed that this is because, for example, when a pressure is locally applied to the base material during processing of the base material, in a case where the temporary adhesive layer has a step, even though the pressure is

evenly applied to the base material, there is breakage in the base material, and the like.

In order to prevent the breakage in the base material, a laminate may be produced by, after flattening a surface of the temporary adhesive layer formed on a surface of the base material or a surface of the support by polishing, grinding, or the like, bonding the temporary adhesive layer with the base material or the support, which is a member different from the member on which the temporary adhesive layer is formed, and then processing of the base material may be performed.

However, in a case where the laminate including a temporary adhesive layer which has been used in the related art is flattened by polishing, grinding, or the like, devices, equipment, and the like used for the polishing or the grinding are clogged, and it is difficult to flatten the surface. As a result, the workability of the base material may be reduced.

As a result of intensive studies by the present inventors, it has been found that, since the temporary adhesive layer contains an inorganic filler, the workability of the base material is improved.

It is presumed that this is because the clogging is eliminated by the action of the above-described inorganic filler.

In addition, in the present invention, it is presumed that, since the temporary adhesive layer contains an inorganic filler, the clogging is eliminated, so that the flattening is performed smoothly, and force applied to the base material by the flattening method (polishing method or grinding method) is easily reduced during the flattening. As a result, it is considered that the breakage in the base material during the flattening and peeling of the temporary adhesive layer from the base material during the flattening are likely to be suppressed.

Figs. 1A to 1F are schematic cross-sectional diagrams showing an example of a manufacturing method of a processed base material according to the embodiment of the present invention.

Fig. 1A shows an example of a state in which a base material 10 including a temporary adhesive layer 12 is formed by a step of forming the temporary adhesive layer 12 by applying a composition for forming a temporary adhesive layer onto a surface of the base material 10.

Fig. 1A is a diagram in which the temporary adhesive layer is tentatively formed on the surface of the base material, but the present invention is not limited thereto. The temporary adhesive layer may be formed on a surface of the support.

In addition, in Fig. 1A, an unevenness is formed on a surface of the temporary adhesive layer 12 on a side opposite to the base material 10 side. The above-described unevenness is derived from, for example, an unevenness (omitted in the drawing) of the surface of the base material 10.

Fig. 1B shows an example of a state in which a surface of the temporary adhesive layer 12 on a side opposite to a surface in contact with the base material is flattened by a step of flattening the above-described temporary adhesive layer 12 by at least one unit of polishing or grinding.

The unevenness formed on the surface of the temporary adhesive layer 12 on the side opposite to the surface in contact with the base material 10, shown in Fig. 1A, is removed by the at least one unit of polishing or grinding in Fig. 1B.

In the present invention, since the temporary adhesive layer 12 contains an inorganic filler, in the flattening by the at least one unit of polishing or grinding, it is considered that the clogging of devices, equipment, and the like used for the polishing or the grinding is suppressed. Therefore, it is presumed that the above-described flattening is smoothly performed, and the surface of the temporary adhesive layer 12, which is subjected to the at least one unit of polishing or grinding, is sufficiently flattened.

Fig. 1C shows an example of a state in which a laminate including the base material 10, the temporary adhesive layer 12, and a support 14 is produced by a step of contacting the above-described flattened surface of the temporary adhesive layer 12 after the above-described flattening with the support 14.

In the step of forming the temporary adhesive layer 12 by applying the composition for forming a temporary adhesive layer as shown in Fig. 1A, tentatively, in a case where the temporary adhesive layer 12 is formed on the surface of the support 14 instead of the base material 10, the step shown in Fig. 1C is a step of contacting the temporary adhesive layer 12 with the base material 10.

Fig. 1D shows an example of a state in which the base material 10 is processed by a step of processing a surface of the above-described base material 10 on a side opposite to the surface in contact with the above-described temporary adhesive layer 12.

In Fig. 1D, the base material 10 is thinned.

Here, as described above, since the temporary adhesive layer 12 according to the present invention contains an inorganic filler, it is presumed that the surface of the temporary adhesive layer 12, which is subjected to the at least one unit of polishing or grinding, is sufficiently flattened, and the breakage and the like in the base material 10 during processing are suppressed.

Fig. 1E shows an example of a state in which the base material 10 and the support 14 are peeled off.

In Fig. 1E, the base material 10 and the support 14 are peeled off at an interface between the temporary adhesive layer 12 and the support 14, but the peeled position is not limited thereto.

For example, the base material 10 and the support 14 may be peeled off at an interface between the temporary adhesive layer 12 and the base material 10, or the temporary adhesive layer 12 may be broken and the post-break

temporary adhesive layer 12 may be present on both the base material 10 and the support 14.

Fig. 1F shows an example of a state in which the temporary adhesive layer 12 is removed from the above-described base material 10.

As described above, with the manufacturing method of a processed base material according to the embodiment of the present invention, a processed base material 10 can be obtained.

Hereinafter, details of each step in the manufacturing method of a processed base material according to the embodiment of the present invention will be described.

<Temporary adhesive layer forming step>

The manufacturing method of a processed base material according to the embodiment of the present invention includes a step (temporary adhesive layer forming step) of forming a temporary adhesive layer by applying a composition for forming a temporary adhesive layer onto a surface of one member of a base material or a support.

It is preferable that the surface of one member of the base material or the support, to which the composition for forming a temporary adhesive layer is applied, has an unevenness, it is more preferable to have an unevenness with a height difference of 0.1 μm or more, it is still more preferable to have an unevenness with a height difference of 1 μm or more, and it is particularly preferable to have an unevenness with a height difference of 2 μm or more.

A shape of the above-described unevenness is not particularly limited, and examples thereof include a columnar shape, a semi-cylindrical shape, a prismatic shape, a spherical crown shape, a polyhedron shape, and a shape obtained by combining these shapes.

The above-described height difference is a value measured as a height difference of the largest step on the surface of the base material, to which the composition for forming a temporary adhesive layer is applied, using a contact type step meter.

In addition, the temporary adhesive layer forming step is preferably a step of forming the temporary adhesive layer by applying the composition for forming a temporary adhesive layer onto the surface of the base material.

[Base material]

The base material is not particularly limited, and various base materials which can be used in a semiconductor process can be used depending on the intended use. As the base material, for example, a transparent substrate used for a liquid crystal display device or the like, or a semiconductor substrate used for a light emitting element, a solid-state imaging element, a semiconductor memory, or the like can be used. In addition, the base material may be a metal substrate, a resin substrate, or a prepreg (a sheet formed by impregnating a fiber member with a resin).

The transparent substrate is, for example, a glass substrate such as quartz glass, alkali-free glass, soda glass, borosilicate glass, and aluminosilicate glass. Other structures such as a transparent conductive film, a reflective film, and a protective film may be formed in these transparent substrates. The semiconductor substrate is, for example, a substrate including silicon, sapphire, silicon carbide, gallium nitride, aluminum, amorphous aluminum oxide, polycrystalline aluminum oxide, silicon nitride, silicon oxynitride, GaAsP, GaP, AlGaAs, InGaN, GaN, AlGaN, ZnSe, AlGa, InP, ZnO, and the like. Other structures such as a PN bonding layer, a light emitting layer, a photoelectric conversion layer, a complementary metal oxide film semiconductor (CMOS) layer, and an electrode layer may be formed in these semiconductor substrates. The metal substrate is, for example, an aluminum substrate, a copper substrate, a stainless steel substrate, or the like. The resin substrate is, for example, an epoxy substrate, a polycarbonate substrate, a flexible substrate (a polyimide substrate, a polyethylene naphthalate (PEN) substrate, and a polyethylene terephthalate (PET) substrate), or the like.

In addition, in order to improve adhesion to the upper layer, prevent diffusion of a substance, or flatten the surface, the base material may include an undercoat layer at a surface layer portion on the side to which the temporary adhesive layer is applied, as necessary. In addition, the base material may include, for example, a semiconductor circuit at the surface layer portion on the side to which the temporary adhesive layer is applied. The base material may be a monolayer structure or a laminated structure.

A thickness (in a case where a structure or the like is included, the maximum thickness) of the base material is not particularly limited, and is appropriately set according to the use of the laminate. The thickness of the base material is, for example, 0.3 to 2 mm. The upper limit of the numerical range is preferably 1.5 mm or less, more preferably 1 mm or less, and still more preferably 0.8 mm or less. In addition, the lower limit of the numerical range is preferably 0.4 mm or more, more preferably 0.5 mm or more, and still more preferably 0.6 mm or more.

A shape of the base material is not particularly limited, and is appropriately set according to the use of the laminate. The shape of the base material is, for example, a disk shape (wafer type substrate) or a rectangular shape (panel type substrate). In a case where the base material has a disk shape, a diameter is, for example, 50 to 500 mm. The upper limit of the numerical range is preferably 400 mm or less, more preferably 300 mm or less, and still more

preferably 250 mm or less. In addition, the lower limit of the numerical range is preferably 100 mm or more, more preferably 150 mm or more, and still more preferably 170 mm or more. On the other hand, in a case where the base material has a rectangular shape, a length of the maximum side is, for example, 200 to 1000 mm. The upper limit of the numerical range is preferably 900 mm or less, more preferably 800 mm or less, and still more preferably 700 mm or less. In addition, the lower limit of the numerical range is preferably 300 mm or more, more preferably 400 mm or more, and still more preferably 450 mm or more. The base material may have an orientation flat or a notch.

For example, the base material may be a base material in which a predetermined structure or semiconductor circuit is formed on the surface on which the temporary adhesive layer is formed, or may be a base material in which a predetermined structure or semiconductor circuit is formed on the surface opposite to the side on which the temporary adhesive layer is formed.

In the present invention, it is also one preferred aspect of a base material in which a predetermined structure or semiconductor circuit is formed on the surface on which the temporary adhesive layer is formed. According to the present invention, for example, in a case where an unevenness is formed in the temporary adhesive layer derived from such a predetermined structure or semiconductor circuit, the unevenness can be flattened to improve the workability of the base material.

[Support]

The support is not particularly limited, and a support known in the art can be used without particular limitation, but the support is preferably in a form of a sheet or a film.

In addition, as the support, for example, a support generally called a dicing tape can be used.

The support may be a monolayer structure or a multilayer structure. That is, the support can include a monolayer or multilayer support film as a base. In addition, the support can include a pressure-sensitive adhesive layer formed on a support film or a support sheet.

Since the support is expanded after processing of the base material (for example, thinning, dicing, and the like) to be peeled off and easily obtained, the support preferably has elasticity. In addition, in a case where a pressure-sensitive adhesive layer formed of an ultraviolet curable resin composition described later is used, the support preferably has light transmittance.

A material of the support film constituting the support is not particularly limited, and may be appropriately selected from known polymer materials for a resin film. As the polymer material constituting the support film, for example, polyolefins such as polyethylene, polypropylene, a copolymer of ethylene and propylene, and polybutene; ethylene copolymers such as a copolymer of ethylene and vinyl acetate, a copolymer of ethylene and (meth)acrylate, a copolymer of ethylene and (meth)acrylic acid ester, and an ionomer including a copolymer of ethylene and (meth)acrylic acid metal salt; polyesters such as polyethylene terephthalate and polybutylene terephthalate; acryl such as poly(methyl methacrylate); polyvinyl chloride, polycarbonate, polyacetal, polyamide, polyimide, polyurethane, polystyrene, natural rubber, synthetic rubber, or the like is preferable. In addition, the support film may be composed of a mixed resin in which two or more kinds selected from these groups are mixed, or may have a structure in which two or more kinds of resins are multi-layered. In a case where the support includes the pressure-sensitive adhesive layer, a material of the support can be optionally selected in consideration of adhesiveness to the pressure-sensitive adhesive layer.

A thickness of the support film or the support sheet is not particularly limited, and is, for example, preferably 50 to 300 μm. The upper limit of the numerical range is preferably 250 μm or less, more preferably 200 μm or less, and still more preferably 160 μm or less. In addition, the lower limit of the numerical range is preferably 60 μm or more, more preferably 70 μm or more, and still more preferably 90 μm or more.

The pressure-sensitive adhesive layer which can constitute the support has sufficient pressure-sensitive adhesiveness to suppress scattering of the base material such as a semiconductor device during dicing. A material of the pressure-sensitive adhesive layer is not particularly limited, and a known pressure-sensitive adhesive material such as an acrylic resin, a urethane resin, and a silicone resin can be included. The pressure-sensitive adhesive layer preferably consists of a curable composition which is cured by applying heat or energy rays. Accordingly, the pressure-sensitive adhesive layer can be appropriately cured by applying heat or energy rays, and pressure-sensitive adhesive force with respect to the temporary adhesive layer can be reduced. As a result, peeling is likely to occur more effectively at the bonding interface between the support and the temporary adhesive layer, and strength of the temporary adhesive layer as a protective film is likely to be ensured. In particular, the above-described curable composition is preferably a composition which is cured by irradiation with energy rays, and more preferably a composition which is cured by irradiation with ultraviolet rays. The curable composition contains, for example, a monomer or an oligomer having a polymerizable functional group, and a polymerization initiator. The pressure-sensitive adhesiveness of the pressure-sensitive adhesive layer can be appropriately controlled by controlling a crosslinking density of the pressure-sensitive adhesive material. The crosslinking density of the pressure-sensitive adhesive material can be controlled by an appropriate method such as a method of crosslinking through an appropriate crosslinking agent such as a polyfunctional isocyanate compound,

an epoxy compound, a melamine compound, a metal salt compound, a metal chelate compound, an amino resin compound, and a peroxide, and a method of mixing a compound which has two or more carbon-carbon double bonds and crosslinking by irradiation with energy rays.

The curable composition may contain one or two or more kinds of other additives such as a polymerization inhibitor, an antioxidant, a leveling agent, a viscosity improver, a viscosity reducer, a surfactant, and a filler, as necessary. Furthermore, from the viewpoint of improving applicability of the composition, the ultraviolet curable composition can contain a solvent.

Details of the dicing tape including the pressure-sensitive adhesive layer composed of the curable composition are described in, for example, JP2010-251722A, the contents of which are incorporated in the present specification.

A thickness of the pressure-sensitive adhesive layer is not particularly limited, and is, for example, preferably 5 to 100 μm. The upper limit of the numerical range is preferably 80 μm or less, more preferably 70 μm or less, and still more preferably 60 μm or less. In addition, the lower limit of the numerical range is more preferably 10 μm or more, and may be 15 μm or more or 20 μm or more.

A thickness of the entire support is preferably 60 to 300 μm. The upper limit of the numerical range is preferably 250 μm or less, more preferably 200 μm or less, and still more preferably 160 μm or less. In addition, the lower limit of the numerical range is preferably 70 μm or more, more preferably 80 μm or more, and still more preferably 100 μm or more.

As the support, a commercially available dicing tape shown below can also be used: HAE-1503, HAE-1603, UC-334EP-85, UC353EP-110A, UC3026M-110, and UC3044M-110B (all of which is manufactured by FURUKAWA ELECTRIC CO., LTD.), UHP-1005AT, UHP-1025M3, USP-1520MG, and UDT-1915MC (all of which is manufactured by Denka Company Limited.), and D-series (manufactured by LINTEC Corporation).

[Composition for forming temporary adhesive layer]

The composition for forming a temporary adhesive layer is a composition containing an inorganic filler, and is preferably a composition containing an inorganic filler and a resin.

Details of the composition for forming a temporary adhesive layer will be described later.

[Method for applying composition for forming temporary adhesive layer]

Examples of a method for applying the composition for forming a temporary adhesive layer include a spin coating method, a slit coating method, a spiral coating method, a spray coating method, a screen printing method, an ink jet method, a cast coating method, a roll coating method, and a dropping method (drop cast). Among these, the application method is preferably a spin coating method, a slit coating method, or a spiral coating method.

In addition, the composition for forming a temporary adhesive layer may be applied by a method of attaching a film of a composition for forming a temporary adhesive layer, which has been formed in advance, to one surface of the base material or the support.

It is not essential that the composition for forming a temporary adhesive layer is applied, for example, to a region of the support, which is not bonded to the base material, an outer region of the base material, which is not used as a chip, or a region of the support, which corresponds to the outer region of the base material. However, one preferred aspect of the present invention also includes an aspect in which the composition for forming a temporary adhesive layer is applied to the entire surface of the base material or the support on the side in contact with the temporary adhesive layer.

[Drying]

The composition for forming a temporary adhesive layer is preferably dried after the application.

A drying unit is not particularly limited, and examples thereof include a known hot plate, a heating type oven, and an infrared oven.

Drying conditions can be appropriately adjusted, and for example, the drying can be performed by heating at 80°C to 270°C (preferably 150°C to 210°C) for 0.5 to 5 minutes (preferably 1 to 4 minutes).

In addition, in the present invention, from the viewpoint of suppressing generation of air bubbles, it is also a preferred aspect to form the temporary adhesive layer by drying the composition for forming a temporary adhesive layer while changing a temperature by 30°C or higher, after applying the composition for forming a temporary adhesive layer.

That is, the above-described step of forming the temporary adhesive layer is preferably a step of forming the temporary adhesive layer by drying the composition for forming a temporary adhesive layer while changing a temperature by 30°C or higher, after applying the composition for forming a temporary adhesive layer.

In a case where the composition for forming a temporary adhesive layer according to the present invention contains an inorganic filler, since a volatilization path of the solvent in the composition for forming a temporary adhesive layer is reduced due to that, the generation of air bubbles may be suppressed by drying the composition for forming a

temporary adhesive layer while changing a temperature by 30°C or higher.

An example of the method of drying while changing the temperature by 30°C or higher is not particularly limited, and examples thereof include an aspect of drying at a temperature A for 1 to 10 minutes and then drying at a temperature B for 1 to 10 minutes.

The above-described temperature A is preferably 60°C to 150°C, and more preferably 70°C to 120°C.

In addition, the above-described temperature B is preferably 90°C to 180°C, and more preferably 100°C to 150°C.

A difference between the temperature A and the temperature B is preferably 30°C or higher, more preferably 40°C or higher, and still more preferably 50°C or higher.

[Temporary adhesive layer]

The temporary adhesive layer contains an inorganic filler, and preferably contains an inorganic filler and a resin.

-Inorganic filler-

The inorganic filler is not particularly limited as long as it is an inorganic substance and is contained in the temporary adhesive layer in a solid state, but it is preferable to include a metal or a metalloid atom.

Examples of the inorganic filler include alumina, titania, zirconia, kaolin, calcined kaolin, talc, pagodite, diatomite, boron nitride, aluminum nitride, calcium carbonate, aluminum hydroxide, magnesium hydroxide, zinc oxide, lithopone, silicate mineral particles (preferably amorphous silica, colloidal silica, calcined gypsum, and silica), magnesium carbonate, titanium oxide, barium carbonate, barium sulfate, mica, and carbon black.

Among these, as the inorganic filler, it is preferable to contain silica or alumina.

A shape of the inorganic filler is not particularly limited, but is preferably in a form of particles.

A shape of the particles is not particularly limited, but is preferably a substantially spherical shape.

In addition, the particles may have a solid shape or a hollow shape.

A particle diameter of the particles is not particularly limited, but a volume average particle size thereof is preferably 0.2 to 20 μm, more preferably 0.3 to 1.5 μm, and still more preferably 0.4 to 1.2 μm.

The volume average particle size can be obtained, for example, by measurement using a dynamic light scattering method. As a measuring device, for example, a nanotrac particle size distribution measuring apparatus UPA-EX150 (manufactured by Nikkiso Co., Ltd.) can be used.

A content of the inorganic filler with respect to the total volume of the temporary adhesive layer is not particularly limited, but is preferably 10% by volume or more, more preferably 20% by volume or more, and still more preferably 30% by volume or more. The upper limit of the above-described content is not particularly limited, but is preferably 90% by volume or less and more preferably 80% by volume or less.

The above-described content is calculated by the following method.

A density of the inorganic filler (density A), a density of the temporary adhesive layer scraped off from the laminate or the base material or the support on which the temporary adhesive layer is formed (density B), and a density of a resultant obtained by forming a layer same as the temporary adhesive layer, except that the inorganic filler is not contained, and scraping off the layer (density C) are measured by a hydrostatic weighing method according to JIS Z 8807 to obtain apparent densities thereof. A filler volume% satisfying a relational expression of (Density A) × (Filler volume%) + (Density C) × { 100% - (Filler volume%)} = (Density B) is calculated. The apparent density means a "density in which a volume occupied by the substance itself and a volume of internal voids are used as a volume of density calculation".

In addition, in a case where it is difficult to calculate the above-described density, the content of the inorganic filler may be calculated from a cross-sectional observation image of the temporary adhesive layer.

The temporary adhesive layer may contain one kind of inorganic filler, or two or more kinds of inorganic fillers may be used in combination. In a case where the temporary adhesive layer contains two or more kinds of inorganic fillers, the total amount thereof is preferably within the above-described range.

In addition, the content of the inorganic filler with respect to the total mass of the temporary adhesive layer is preferably 30% to 95% by mass, more preferably 40% to 90% by mass, and still more preferably 50% to 85% by mass.

-Resin-

The temporary adhesive layer preferably contains a resin.

The temporary adhesive layer preferably contains a non-curable resin. In the present specification, the "non-curable" means property of not increasing hardness (Rockwell hardness) by the action of heat (for example, 150°C or higher, preferably 200°C or higher) or light (for example, light in at least any band in a wavelength range of 180 to 800

nm, preferably light having a wavelength of 200 to 400 nm). As a result, removal of the temporary adhesive layer is easier.

Furthermore, the temporary adhesive layer preferably contains a thermoplastic resin (resin which is soft in a case of being heated to a glass transition point or a melting point). As a result, removal of the temporary adhesive layer is easier.

The temporary adhesive layer also preferably contains a water-insoluble resin. In the present specification, the "water-insoluble" means property in which saturated solubility (g) in 100 g of water at 23°C is 1 g or less. As a result, protective function in a case where a subsequent step using water is performed is further improved. With regard to the water-insoluble resin, the saturated solubility in 100 g of water at 23°C is preferably 0.9 g or less, more preferably 0.5 g or less, and still more preferably 0.1 g or less. In addition, with regard to the water-insoluble resin, the saturated solubility in water at 23°C is practically 0.001 g or more, and may be 0.01 g or more.

The temporary adhesive layer also preferably contains a transparent resin. As a result, for example, in a step after dicing, the surface of the base material covered with the temporary adhesive layer can be visually recognized. In a case where the temporary adhesive layer contains a transparent resin, the minimum light transmittance of a temporary adhesive layer having a thickness of 50 mm in a wavelength range of 400 to 700 nm is preferably 85% or more, more preferably 88% or more, and still more preferably 90% or more. In addition, the above-described minimum light transmittance of the temporary adhesive layer is preferably 99.9% or less, and may be 98% or less.

In particular, the temporary adhesive layer preferably contains a non-curable and water-insoluble resin or a thermoplastic and water-insoluble resin, more preferably contains a non-curable, water-insoluble, and transparent resin or a thermoplastic, water-insoluble, and transparent resin, and still more preferably contains a thermoplastic, water-insoluble, and transparent resin.

In particular, the temporary adhesive layer preferably contains at least one resin selected from the group consisting of polyvinyl acetal, polyalkyl methacrylate, and acyl cellulose, more preferably contains at least one resin selected from the group consisting of polyvinyl acetal and polyalkyl methacrylate, and still more preferably contains polyvinyl acetal.

«Polyvinyl acetal»

The polyvinyl acetal is preferably a resin obtained by reacting polyvinyl alcohol with an aldehyde to be acetalized, and more preferably a compound including each repeating unit represented by Formula (PV-1).

Formula (PV-1):

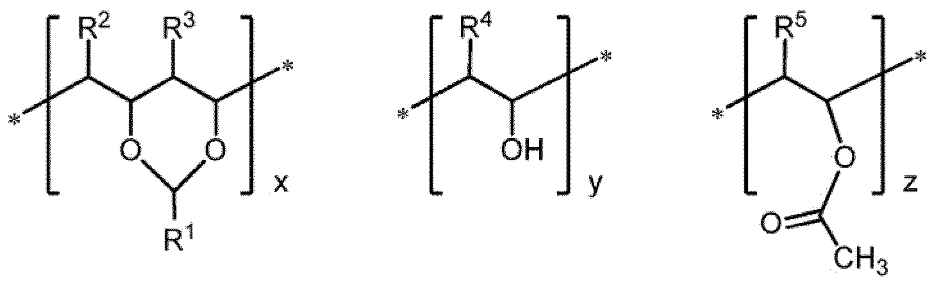

In Formula (PV-1), $R^1$ represents an alkyl group, $R^2$ to $R^5$ each independently represent a hydrogen atom or a monovalent substituent, x, y, and z each represent a molar ratio (mol%) of each repeating unit in the resin, and x + y + z is 80 to 100 mol%. In addition, an asterisk "*" represents a bond or a terminal site between repeating units.

$R^1$ is preferably an alkyl group having 1 to 10 carbon atoms, more preferably an alkyl group having 1 to 5 carbon atoms, and still more preferably an alkyl group having 2 or 3 carbon atoms. In particular, it is more preferable that $R^1$ is a propyl group ($-C_3H_7$), that is, the polyvinyl acetal is polyvinyl butyral.

$R^2$ to $R^5$ are preferably a hydrogen atom. On the other hand, in a case where $R^2$ to $R^5$ represent a monovalent substituent, the monovalent substituent is preferably, for example, the following substituent T. In addition, in a case where $R^2$ to $R^5$ represent a monovalent substituent, $R^2$'s between different repeating units may be the same or different from each other, $R^3$'s between different repeating units may be the same or different from each other, $R^4$'s between different repeating units may be the same or different from each other, and $R^5$'s between different repeating units may be the same or different from each other.

Examples of the substituent T include one selected from a halogen atom, a cyano group, a nitro group, a hydrocarbon group, a heterocyclic group, $-ORt^1$, $-CORt^1$, $-COORt^1$, $-OCORt^1$, $-NRt^1Rt^2$, $-NHCORt^1$, $-CONRt^1Rt^2$, $-NHCONRt^1Rt^2$, $-NHCOORt^1$, $-SRt^1$, $-SO_2Rt^1$, $-SO_2ORt^1$, $-NHSO_2Rt^1$, and $-SO_2NRt^1Rt^2$. Here, $Rt^1$ and $Rt^2$ each independently represent a hydrogen atom, a hydrocarbon group, or a heterocyclic group. In a case where $Rt^1$ and $Rt^2$ are

hydrocarbon groups, $Rt^1$ and $Rt^2$ may be bonded to each other to form a ring.

Regarding the substituent T, examples of the halogen atom include a fluorine atom, a chlorine atom, a bromine atom, and an iodine atom. Examples of the hydrocarbon group include an alkyl group, an alkenyl group, an alkynyl group, and an aryl group. The number of carbon atoms in the alkyl group is preferably 1 to 10, more preferably 1 to 5, and still more preferably 1 or 2. The alkyl group may be linear, branched, or cyclic, and is preferably linear or branched. The number of carbon atoms in the alkenyl group is preferably 2 to 10, more preferably 2 to 5, and particularly preferably 2 or 3. The alkenyl group may be linear, branched, or cyclic, and is preferably linear or branched. The number of carbon atoms in the alkynyl group is preferably 2 to 10 and more preferably 2 to 5. The alkynyl group may be linear or branched. The number of carbon atoms in the aryl group is preferably 6 to 10, more preferably 6 to 8, and still more preferably 6 or 7. The heterocyclic group may be a single ring or a polycyclic ring. The heterocyclic group is preferably a single ring or a polycyclic ring having 2 to 4 rings. The number of heteroatoms constituting the ring of the heterocyclic group is preferably 1 to 3. The heteroatom constituting the ring of the heterocyclic group is preferably a nitrogen atom, an oxygen atom, or a sulfur atom. The number of carbon atoms constituting the ring of the heterocyclic group is preferably 3 to 10, more preferably 3 to 8, and still more preferably 3 to 5.

The hydrocarbon group and the heterocyclic group as the substituent T may further have another substituent or may be unsubstituted. Examples of the other substituent here include the above-described substituents T.

Specifically, for example, the above-described substituent T is a halogen atom (particularly, a fluorine atom, a chlorine atom, or a bromine atom), an alkyl group having 1 to 5 carbon atoms (particularly, a methyl group, an ethyl group, or a propyl group), an alkenyl group having 2 to 5 carbon atoms (particularly, an ethenyl group (vinyl group) or a propenyl group), an alkoxy group having 1 to 5 carbon atoms (particularly, a methoxy group, an ethoxy group, or a propoxy group), a hydroxyl group, a thiol group, a carbonyl group, a thiocarbonyl group, a carboxy group, an amino group, a nitro group, a phenyl group, or the like. In particular, the substituent T is preferably a fluorine atom, a methyl group, an ethyl group, a methoxy group, an ethoxy group, a hydroxyl group, a carbonyl group, or a carboxy group. These substituents may further have another substituent or may be unsubstituted.

$x + y + z$ is preferably 85 to 100 mol%. The upper limit of the numerical range is generally 100 mol%, but may be approximately 98 mol%. The lower limit of the numerical range is more preferably 90 mol% or more and still more preferably 95 mol% or more. That is, the polyvinyl acetal may contain a repeating unit other than the above-described three repeating units, but a molar ratio of such other repeating units is preferably 0 to 20 mol%, more preferably 0 to 10 mol%, still more preferably 0 to 5 mol%, and particularly preferably 0 mol%. x corresponds to a degree of acetalization in the polyvinyl acetal resin, and is preferably 50 to 90 mol%. The upper limit of the numerical range is preferably 85 mol% or less, more preferably 80 mol% or less, and still more preferably 76 mol% or less. In addition, the lower limit of the numerical range is preferably 60 mol% or more, more preferably 65 mol% or more, and still more preferably 70 mol% or more. y corresponds to a content of hydroxyl group in the polyvinyl acetal resin, and is preferably 10 to 50 mol%. The upper limit of the numerical range is preferably 40 mol% or less, more preferably 35 mol% or less, and still more preferably 30 mol% or less. In addition, the lower limit of the numerical range is preferably 15 mol% or more, more preferably 20 mol% or more, and still more preferably 24 mol% or more. z corresponds to a content of acetyl group in the polyvinyl acetal resin, and is preferably 1 to 5 mol%. The upper limit of the numerical range is preferably 4 mol% or less, more preferably 3.5 mol% or less, and still more preferably 3 mol% or less. In addition, the lower limit of the numerical range is preferably 1.5 mol% or more, more preferably 1.7 mol% or more, and still more preferably 2 mol% or more.

A weight-average molecular weight of the polyvinyl acetal is preferably 10,000 to 300,000. The upper limit of the numerical range is more preferably 200,000 or less, more preferably 150,000 or less, and particularly preferably 120,000 or less. In addition, the lower limit of the numerical range is preferably 20,000 or more, more preferably 50,000 or more, and still more preferably 80,000 or more.

In the temporary adhesive layer containing polyvinyl acetal, a content of the polyvinyl acetal in the temporary adhesive layer is preferably 5% to 50% by mass. The upper limit of the numerical range may be 45% by mass or less, 40% by mass or less, or 35% by mass or less. In addition, the lower limit of the numerical range is preferably 8% by mass or more, more preferably 10% by mass or more, and still more preferably 15% by mass or more. The polyvinyl acetal in the temporary adhesive layer may be composed of one kind alone or a mixture including two or more kinds of polyvinyl acetals. In a case where the polyvinyl acetal is a mixture, the total amount thereof is preferably within the above-described range.

«Polyalkyl methacrylate»

The polyalkyl methacrylate is more preferably a compound including each repeating unit represented by Formula (PM-1).

Formula (PM-1)::

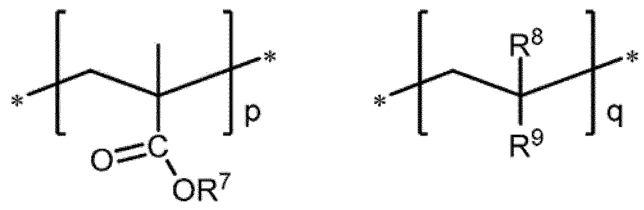

In Formula (PM-1), $R^7$ represents an alkyl group, $R^8$ represents a hydrogen atom or a methyl group, $R^9$ represents a monovalent organic group, p and q each represent a molar ratio of each repeating unit in the resin, p is 60 to 100 mol%, q is 0 to 40 mol%, and p + q is 80 to 100 mol%. In addition, an asterisk "*" represents a bond or a terminal site between repeating units. The repeating unit in which q is attached is a repeating unit which does not satisfy the requirement of the repeating unit in which p is attached.

With regard to the repeating unit in which p is attached, p is preferably 80 mol% or more, more preferably 90 mol% or more, and still more preferably 95 mol% or more. In addition, p may be 98 mol% or less. $R^7$ is preferably an alkyl group having 1 to 10 carbon atoms, more preferably an alkyl group having 1 to 5 carbon atoms, and still more preferably an alkyl group having 1 or 3 carbon atoms. In particular $R^7$ is preferably a methyl group. $R^7$'s between different repeating units may be different from each other, but it is preferable to be the same. Furthermore, the polyalkyl methacrylate is preferably polymethyl methacrylate (PMMA) in which p is 90 mol% or more and $R^7$ is a methyl group.

With regard to the repeating unit in which q is attached, q is preferably 20 mol% or less, more preferably 10 mol% or less, and still more preferably 5 mol% or more. In addition, q may be 2 mol% or more.

Furthermore, the repeating unit in which q is attached is preferably a repeating unit derived from (meth)acrylate which does not satisfy the requirement of the repeating unit in which p is attached. Examples of such a repeating unit include a case where, in the repeating unit in which q is attached, $R^8$ is a hydrogen atom, or a case where, in the repeating unit in which q is attached, $R^8$ is a methyl group and $R^9$ is -COOR10 (R10 is an organic group other than an alkyl group).

Furthermore, the repeating unit in which q is attached is also preferably a repeating unit represented by Formula (PM-2).

Formula (PM-2):

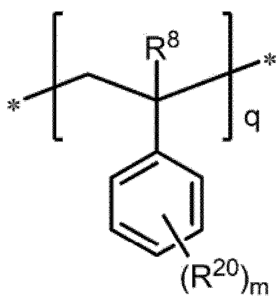

In Formula (PM-2) $R^8$ has the same meaning as $R^8$ in Formula (PM-1), $R^{20}$ represents a monovalent substituent, and m represents an integer of 0 to 4. Here, examples of the substituent include the above-described substituent T, and specific examples thereof include a fluorine atom, a methyl group, an ethyl group, a methoxy group, an ethoxy group, a hydroxyl group, a carbonyl group, and a carboxy group. In addition, these groups may further have a substituent. m may be 3 or less or 1 or more.

In addition, a hydrogen atom in the polyalkyl methacrylate may be substituted with a substituent. Examples of the substituent include the above-described substituent T, and specific examples thereof include a fluorine atom, a methyl group, an ethyl group, a methoxy group, an ethoxy group, a hydroxyl group, a carbonyl group, and a carboxy group.

A weight-average molecular weight of the polyalkyl methacrylate is preferably 10,000 to 300,000. The upper limit of the numerical range is more preferably 200,000 or less, more preferably 150,000 or less, and particularly preferably 120,000 or less. In addition, the lower limit of the numerical range is preferably 20,000 or more, more preferably 50,000 or more, and still more preferably 80,000 or more.

In the temporary adhesive layer containing polyalkyl methacrylate, a content of the polyalkyl methacrylate in the temporary adhesive layer is preferably 5% to 50% by mass. The upper limit of the numerical range may be 45% by mass or less, 40% by mass or less, or 35% by mass or less. In addition, the lower limit of the numerical range is preferably 8% by mass or more, more preferably 10% by mass or more, and still more preferably 15% by mass or more. The

polyalkyl methacrylate in the temporary adhesive layer may be composed of one kind alone or a mixture including two or more kinds of polyalkyl methacrylates. In a case where the polyalkyl methacrylate is a mixture, the total amount thereof is preferably within the above-described range.

«Acyl cellulose»

The acyl cellulose is a compound obtained by acyl-esterifying cellulose, and is more preferably a compound represented by Formula (AC-1).

Formula (AC-1):

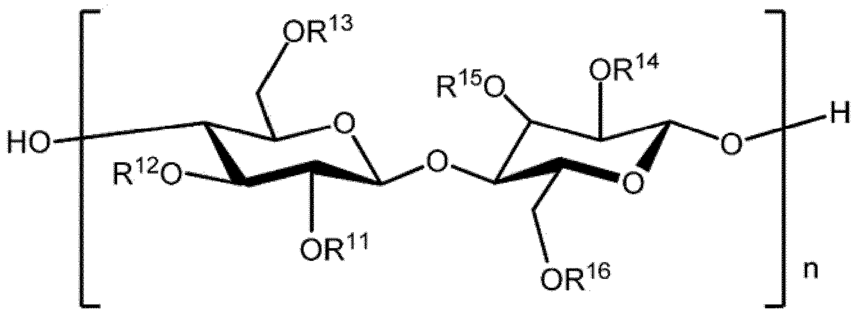

In Formula (AC-1), $R^{11}$ to $R^{16}$ each independently represent a hydrogen atom or an acyl group (-$COR^{17}$; $R^{17}$ is an alkyl group), at least one of $R^{11}$ to $R^{16}$ is an acyl group, and n represents a degree of polymerization.

With regard to $R^{11}$ to $R^{16}$, the alkyl group $R^{17}$ in the acyl group is preferably an alkyl group having 1 to 10 carbon atoms, more preferably an alkyl group having 1 to 5 carbon atoms, and still more preferably an alkyl group having 1 or 3 carbon atoms. In particular, it is preferable that $R^{17}$ is a methyl group, that is, the acyl group is an acetyl group and the acyl cellulose is cellulose acetate. In the same repeating unit or between different repeating units, the types of acyl groups are generally the same, but may be partially different from each other.

With regard to $R^{11}$ to $R^{16}$ in the same repeating unit, it is preferable that at least two thereof are acyl groups, it is more preferable that at least four thereof are acyl groups, and all six may be acyl groups. Between different repeating units, the number of acyl groups may be the same or different from each other. An acylation degree (proportion of carboxylic acid liberated by saponifying the acyl cellulose; in particular, in a case where the acyl cellulose is cellulose acetate, also referred to as an acetylation degree), which represents a degree of acyl esterification, is preferably 35% to 75%. The upper limit of the numerical range is preferably 70% or less, more preferably 65% or less, and still more preferably 60% or less. In addition, the lower limit of the numerical range is preferably 40% or more, more preferably 45% or more, and still more preferably 50% or more. In addition, a degree of substitution, which represents a degree of substitution of the acyl group, is preferably 0.1 to 3. The upper limit of the numerical range is preferably 2.9 or less, more preferably 2.8 or less, and still more preferably 2.7 or less. In addition, the lower limit of the numerical range is preferably 0.2 or more, more preferably 0.3 or more, and still more preferably 0.4 or more. Here, the above-described degree of substitution means an average number of acetylated (acylated) groups out of three hydroxyl groups per glucose unit. The cellulose acetate may have, for example, the above-described substituent T.

In addition, a hydrogen atom at the terminal in Formula (AC-1) may be substituted with a substituent (for example, another sugar).

A weight-average molecular weight of the acyl cellulose is preferably 10,000 to 300,000. The upper limit of the numerical range is more preferably 200,000 or less, more preferably 150,000 or less, and particularly preferably 120,000 or less. In addition, the lower limit of the numerical range is preferably 20,000 or more, still more preferably 50,000 or more, and still more preferably 80,000 or more.

In the temporary adhesive layer containing acyl cellulose, a content of the acyl cellulose in the temporary adhesive layer is preferably 5% to 50% by mass. The upper limit of the numerical range may be 45% by mass or less, 40% by mass or less, or 35% by mass or less. In addition, the lower limit of the numerical range is preferably 8% by mass or more, more preferably 10% by mass or more, and still more preferably 15% by mass or more. The acyl cellulose in the temporary adhesive layer may be composed of one kind alone or a mixture including two or more kinds of acyl celluloses. In a case where the acyl cellulose is a mixture, the total amount thereof is preferably within the above-described range.

«Elastomer»

As the resin used for the temporary adhesive layer, for example, an elastomer can also be used. In a case where the temporary adhesive layer contains an elastomer, it is possible to form a film which has excellent adhesiveness by following fine unevenness of the base material or the support and by an appropriate anchor effect. In addition, in a case of peeling off the base material from the support, application of stress to the base material is suppressed, so that the base material can be easily can be easily peeled off from the support and the device or the like on the base material can be prevented from being damaged or falling off.

In the present specification, the elastomer means a polymer compound exhibiting elastic deformation. That is, the elastomer is a polymer compound having a property of being instantly deformed according to an external force in a case where the external force is applied and of being recovered to an original shape in a short time in a case where the external force is removed. For example, the elastomer can be elastically deformed to a length of 200% by applying an external force and pulling both ends in a case where a length of the original shape at room temperature (23°C) is set as 100%, and in a case where the external force is removed, the elastomer preferably has a property of returning to 130% of its length in a short period of time.

In the elastomer of the present invention, a 5% thermal mass reduction temperature from 25°C at 20 °C/min is 375°C or higher, preferably 380°C or higher, more preferably 390°C or higher, and most preferably 400°C or higher. In addition, the upper limit value thereof is not particularly limited, but is preferably 1000°C or lower and more preferably 800°C or lower. According to this aspect, it is easy to form a film such as a sheet, having excellent heat resistance. The mass reduction temperature is a value measured by a thermogravimetric analyzer (TGA) under the above-described temperature rising condition in a nitrogen stream. In a case where the composition according to the present invention contains two or more kinds of elastomers, the mass reduction temperature means a value in a mixture of the two or more kinds of elastomers.

In the present invention, a glass transition temperature (hereinafter, also referred to as "Tg") of the elastomer is preferably -50°C to 300°C and more preferably 0°C to 200°C. In a case where Tg is within the above-described range, it is possible to form a film such as a sheet, in which followability to a surface of a device wafer during bonding is good and there is no void. In a case where the elastomer has two or more points of Tg, the above-described value of Tg means a lower glass transition temperature.

In the present invention, a weight-average molecular weight of the elastomer is preferably 2,000 to 200,000, more preferably 10,000 to 200,000, and particularly preferably 50,000 to 100,000. Within this range, since the elastomer exhibits excellent solubility in a solvent, there is an advantage that a residue is less likely to remain on the base material in a case where the temporary adhesive layer is removed.

In the present invention, as the elastomer, an elastomer including a repeating unit derived from styrene (polystyrene-based elastomer), a polyester-based elastomer, a polyolefin-based elastomer, a polyurethane-based elastomer, a polyamide-based elastomer, a polyacryl-based elastomer, a silicone-based elastomer, a polyimide-based elastomer, or the like can be used. At least one selected from a polystyrene-based elastomer, a polyester-based elastomer, a polyolefin-based elastomer, a polyurethane-based elastomer, a polyamide-based elastomer, a polyacryl-based elastomer, a silicone-based elastomer, or a polyimide-based elastomer is preferable, and from the viewpoint of solubility, heat resistance, and the like, a polystyrene-based elastomer is particularly preferable.

The polystyrene-based elastomer is not particularly limited, and can be appropriately selected depending on the purpose. Examples thereof include a styrene-butadiene-styrene block copolymer (SBS), a styrene-isoprene-styrene block copolymer (SIS), a styrene-ethylene-styrene block copolymer (SEBS), a styrene-butadiene-butylene-styrene copolymer (SBBS), a hydrogenated product of these copolymers, a styrene-ethylene-propylene-styrene block copolymer (SEPS), and a styrene-ethylene-ethylene-propylene-styrene block copolymer.

A content of the repeating unit derived from styrene in the polystyrene-based elastomer is preferably 40% by mass or more, more preferably 45% by mass or more, and still more preferably 46% by mass or more. The upper limit thereof may be, for example, 90% by mass or less or 85% by mass or less.

The polystyrene-based elastomer is preferably a block copolymer of styrene and another monomer, more preferably a block copolymer in which either or both terminals are styrene blocks, and particularly preferably a block copolymer in which both terminals are styrene blocks. In a case where both terminals of the polystyrene-based elastomer are styrene blocks (repeating units derived from styrene), the heat resistance is further improved. This is because the repeating unit derived from styrene having high heat resistance is present at the terminal. In particular, since the styrene block is a reactive polystyrene-based hard block, the polystyrene-based elastomer tends to be more excellent in heat resistance and chemical resistance, which is preferable. In addition, it is considered that, by using an elastomer which is a block copolymer, phase separation between the hard block and the soft block occurs at 200°C. It is considered that a shape of the phase separation contributes to suppression of the occurrence of unevenness on the substrate surface of the device wafer. In addition, such an elastomer is more preferable from the viewpoint of solubility in a solvent and resistance to a resist solvent.

In addition, in a case where the polystyrene-based elastomer is a hydrogenated product, stability with respect to heat is improved, and change in quality, such as decomposition and polymerization, is unlikely to occur. Furthermore, it is more preferable from the viewpoint of solubility in a solvent and resistance to a resist solvent.

In the present specification, the "repeating unit derived from styrene" is a constitutional unit derived from styrene which is included in a polymer in a case of polymerizing styrene or a styrene derivative, and may have a substituent. Examples of the styrene derivative include $\alpha$-methylstyrene, 3-methylstyrene, 4-propylstyrene, and 4-cyclohexylstyrene. Examples of the substituent include an alkyl group having 1 to 5 carbon atoms, an alkoxy group having 1 to 5 carbon atoms, an alkoxyalkyl group having to 5 carbon atoms, an acetoxy group, and a carboxy group.

Details of other elastomers (for example, a polyester-based elastomer, a polyolefin-based elastomer, a polyurethane-based elastomer, a polyamide-based elastomer, a polyacryl-based elastomer, a silicone-based elastomer, and a polyimide-based elastomer) are described in, for example, JP2018-037558A, the contents of which are incorporated in the present specification.

In addition, the elastomer is preferably a hydrogenated product. In particular, a hydrogenated product of the polystyrene-based elastomer is preferable. In a case where the elastomer is a hydrogenated product, it is easy to form a film such as a sheet, having excellent heat resistance. Furthermore, it is easy to form a film such as a sheet, having excellent peelability and wash-removability after peeling. The above-described effects are remarkable in a case where the hydrogenated product of the polystyrene-based elastomer is used. The hydrogenated product means a polymer having a structure in which an elastomer is hydrogenated.

In addition, with respect to the total mass of the elastomer, the elastomer contains the polystyrene-based elastomer in an amount of preferably 10% to 100% by mass, more preferably 80% to 100% by mass, still more preferably 90% to 100% by mass, and even more preferably 95% to 100% by mass, and it is particularly preferable that the elastomer is substantially composed of the polystyrene-based elastomer. Furthermore, among these, it is more preferable that the hydrogenated product of the polystyrene-based elastomer is contained in the above-described proportion.

In the temporary adhesive layer containing elastomer, a content of the elastomer in the temporary adhesive layer is preferably 5% to 50% by mass. The upper limit of the numerical range may be 45% by mass or less, 40% by mass or less, or 35% by mass or less. In addition, the lower limit of the numerical range is preferably 8% by mass or more, more preferably 10% by mass or more, and still more preferably 15% by mass or more. The elastomer may include a plurality of above-described types. In a case where the resin in the temporary adhesive layer contains a plurality of elastomers, the total amount thereof is preferably within the above-described range.

<<Other thermoplastic resins>>

In the present invention, a thermoplastic resin other than the above-described polyvinyl acetal, polymethyl methacrylate, cellulose acetate, and elastomer (hereinafter, also simply referred to as "other thermoplastic resins") can also be used. The other thermoplastic resins may be used alone or in combination of two or more kinds thereof. Specific examples of the other thermoplastic resins include an acrylic resin, a polyvinyl alcohol resin, a polyvinyl acetal resin, a polyvinylpyrrolidone resin, a cycloolefin resin, a thermoplastic siloxane resin, an unsaturated polyester resin, a thermoplastic polyimide resin, a polyvinyl chloride resin, a polyvinyl acetate resin, a polycarbonate resin, a polyphenylene ether resin, a polybutylene terephthalate resin, a polyethylene terephthalate resin, a polyphenylene sulfide resin, polysulfone resin, a polyethersulfone resin, a polyarylate resin, and a cellulose resin.

Examples of the acrylic resin as the other thermoplastic resins include 2-ethylhexyl (meth)acrylate, ethyl (meth)acrylate, n-propyl (meth)acrylate, isopropyl (meth)acrylate, pentyl (meth)acrylate, n-octyl (meth)acrylate, isooctyl (meth)acrylate, isononyl (meth)acrylate, n-butyl (meth)acrylate, isobutyl (meth)acrylate, hexyl (meth)acrylate, n-nonyl (meth)acrylate, isoamyl (meth)acrylate, n-decyl (meth)acrylate, isodecyl (meth)acrylate, dodecyl (meth)acrylate, isobornyl (meth)acrylate, cyclohexyl (meth)acrylate, phenyl (meth)acrylate, benzyl (meth)acrylate, and 2-methylbutyl (meth)acrylate. In addition to the above, examples thereof include ACRYPET MF 001 manufactured by MITSUBISHI RAYON CO.,LTD., and LC-5320 F1035 manufactured by 3M Japan.

In addition, the acrylic resin may be a compound obtained by copolymerizing a (meth)acrylate monomer with another monomer without departing from the spirit of the present invention. In a case where the (meth)acrylate monomer is copolymerized with another monomer, an amount of another monomer is preferably 10 mol% or less of all monomers.

A content of the resin in the temporary adhesive layer is preferably 8% by mass or more with respect to the total mass of the temporary adhesive layer. In particular, the upper limit of the numerical range is preferably 80% by mass or less, more preferably 70% by mass or less, still more preferably 60% by mass or less, and particularly preferably 50% by mass or less. In addition, the lower limit of the numerical range is preferably 10% by mass or more, more preferably 11% by mass or more, and still more preferably 12% by mass or more. The resin in the temporary adhesive layer may be composed of one kind alone or a mixed resin including two or more kinds of resins. In a case where the resin is a mixed resin, the total amount thereof is preferably within the above-described range.

-Peeling agent-

The temporary adhesive layer may contain a peeling agent.

Examples of the peeling agent include a compound including a fluorine atom and a compound including a silicon atom, and a fluorine-based surfactant or a silicone-based surfactant is preferable.

A fluorine content in the fluorine-based surfactant is suitably 3% to 40% by mass. Here, the fluorine content is a proportion of mass of all fluorine atoms to the molecular weight. The upper limit of the fluorine content is more preferably 30% by mass or less, and particularly preferably 25% by mass or less. In addition, the lower limit thereof is more preferably 5% by mass or more, and particularly preferably 7% by mass or more. The surfactant in which the fluorine content is within the above-described range is effective from the viewpoint of uniformity in the thickness of the coating film and liquid saving property, and the peelability of the temporary adhesive layer is also good.

The fluorine-based surfactant is not particularly limited, but a fluorine-based surfactant which does not contain perfluorooctanoic acid (PFOA) or perfluorooctanesulfonic acid (PFOS) is preferable. Examples of the fluorine-based surfactant which can be used in the present invention include MEGAFACE F142D, F172, F173, F176, F177, F183, F479, F482, F554, F780, F781, F781-F, R30, R08, F-472SF, BL20, R-61, and R-90 (manufactured by DIC Corporation); FLUORAD FC-135, FC-170C, FC-430, FC-431, and NovecFC-4430 (manufactured by Sumitomo 3M Ltd.); AsahiGuard AG7105, AG7000, AG950, AG7600, SURFLON S-112, S-113, S-131, S-141, S-145, S-381, S-382, SC-101, SC-102, SC-103, SC-104, SC-105, and SC-106 (manufactured by AGC SEIMI CHEMICAL CO., LTD.); EFTOP EF301, EF303, EF351, EF352, EF801, and EF802 (manufactured by Mitsubishi Materials Electronic Chemicals Co., Ltd.); and

FTERGENT 250 (manufactured by NEOS COMPANY LIMITED), which are commercially available products. In addition to the above, examples thereof include each series of KP (manufactured by Shin-Etsu Chemical Co., Ltd.), POLYFLOW (manufactured by KYOEISHA CHEMICAL CO., LTD.), PolyFox (manufactured by OMNOVA Solutions Inc.), and the like.

The silicone-based surfactant is a compound including a Si-O bond, examples thereof include a silicone oil, a silane coupling agent, a silicone resin, a silicone rubber, and a cyclic siloxane, and a silicone oil is preferable.

In addition, it is preferable that the silicone-based surfactant does not include a reactive group such as a polymerizable group.

The silicone-based surfactant is preferably a polyether-modified silicone. In the polyether-modified silicone, a ratio represented by Expression (A) is 80% or more.

$$[0106]\ \text{Expression (A)} \qquad \{(MO + EO)/AO\} \times 100$$

In Expression (A), MO is a mol% of methylene oxide included in a polyether structure of the polyether-modified silicone, EO is a mol% of ethylene oxide included in the polyether structure of the polyether-modified silicone, and AO is a mol% of alkylene oxide included in the polyether structure of the polyether-modified silicone.

The ratio represented by Expression (A) is preferably 90% or more, more preferably 95% or more, still more preferably 98% or more, even more preferably 99% or more, and even more preferably 100%.

A weight-average molecular weight of the polyether-modified silicone is preferably 500 to 100000, more preferably 1000 to 50000, and still more preferably 2000 to 40000.

In the polyether-modified silicone, it is preferable that a mass reduction ratio in a case where, under a nitrogen stream of 60 mL/min, the polyether-modified silicone is heated from 20°C to 280°C at a heating rate of 20 °C/min and held at a temperature of 280°C for 30 minutes is 50% by mass or less. By using such a compound, surface property of the substrate after being processed with heat is further improved. The mass reduction ratio of the polyether-modified silicone is preferably 45% by mass or less, more preferably 40% by mass or less, still more preferably 35% by mass or less, and even more preferably 30% by mass or less. The lower limit value of the above-described mass reduction ratio of the polyether-modified silicone may be 0% by mass, but a sufficiently practical level is 15% by mass or more, and further 20% by mass or more.

A light refractive index of the polyether-modified silicone is preferably 1.440 or less. The lower limit value thereof is not particularly limited, but a sufficiently practical level is 1.400 or more.

A content of a polyoxyalkylene group in the molecule of the polyether-modified silicone is not particularly limited, but it is desirable that the content of the polyoxyalkylene group is more than 1% by mass with respect to the total molecular weight.

The content of the polyoxyalkylene group is defined by "{(formula weight of polyoxyalkylene group in one molecule)/molecular weight of one molecule} × 100".

Examples of the silane coupling agent include a fluorine atom-containing silane coupling agent, and triethoxy(1H,1H,2H,2H-nonafluorohexyl) silane is preferable.

Furthermore, examples of the silane coupling agent include surfactants described in each of JP1987-036663A (JP-S62-036663A), JP1986-226746A (JP-S61-226746A), JP1986-226745A (JP-S61-226745A), JP1987-170950A (JP-S62-170950A), JP1988-034540A (JP-S63-034540A), JP1995-230165A (JP-H07-230165A), JP1996-062834A (JP-H08-062834A), JP1997-054432A (JP-H09-054432A), JP1997-005988A (JP-H09-005988A), and JP2001-330953A, the description of which is incorporated herein by reference.

As the silicone-based surfactant used in the present invention, a commercially available product can also be used.

Examples thereof include "ADVALON FA33", "FLUID L03", "FLUID L033", "FLUID L051", "FLUID L053", "FLUID L060", "FLUID L066", "IM22", "WACKER-Belsil DMC 6038" (all of which is manufactured by Wacker AsahiKasei Silicone Co., Ltd.), "KF-352A", "KF-353", "KF-615A", "KP-112", "KP-341", "X-22-4515", "KF-354L", "KF-355A", "KF-6004", "KF-6011", "KF-6011P", "KF-6012", "KF-6013", "KF-6015", "KF-6016", "KF-6017", "KF-6017P", "KF-6020", "KF-6028", "KF-6028P", "KF-6038", "KF-6043", "KF-6048", "KF-6123", "KF-6204", "KF-640", "KF-642", "KF-643", "KF-644", "KF-945", "KP-110", "KP-355", "KP-369", "KS-604", "Polon SR-conc", "X-22-4272", "X-22-4952" (all of which is manufactured by Shin-Etsu Chemical Co., Ltd.), "8526 ADDITIVE", "FZ-2203", "FZ-5609", "L-7001", "SF 8410", "2501 COSMETIC WAX", "5200 FORMULATION AID", "57 ADDITIVE", "8019 ADDITIVE", "8029 ADDITIVE", "8054 ADDITIVE", "BY16-036", "BY16-201", "ES-5612 FORMULATION AID", "FZ-2104", "FZ-2108", "FZ-2123", "FZ-2162", "FZ-2164", "FZ-2191", "FZ-2207", "FZ-2208", "FZ-2222", "FZ-7001", "FZ-77", "L-7002", "L-7604", "SF8427", "SF8428", "SH 28 PAINR ADDITIVE", "SH3749", "SH3773M", "SH8400", "SH8700" (all of which is manufactured by Dow Corning Toray Co., Ltd.), "BYK-378", "BYK-302", "BYK-307", "BYK-331", "BYK-345", "BYK-B", "BYK-347", "BYK-348", "BYK-349", "BYK-377" (all of which is manufactured by BYK Japan K.K.), "Silwet L-7001", "Silwet L-7002", "Silwet L-720", "Silwet L-7200", "Silwet L-7210", "Silwet L-7220", "Silwet L-7230", "Silwet L-7605", "TSF4445", "TSF4446", "TSF4452", "Silwet Hydrostable 68", "Silwet L-722", "Silwet L-7280", "Silwet L-7500", "Silwet L-7550", "Silwet L-7600", "Silwet L-7602", "Silwet L-7604", "Silwet L-7607", "Silwet L-7608", "Silwet L-7622", "Silwet L-7650", "Silwet L-7657", "Silwet L-77", "Silwet L-8500", "Silwet L-8610", "TSF4440", "TSF4441", "TSF4450", and "TSF4460" (all of which is manufactured by Momentive Performance Materials Inc.).

In addition, as the silicone-based surfactant, trade name "BYK-300", "BYK-306", "BYK-310", "BYK-315", "BYK-313", "BYK-320", "BYK-322", "BYK-323", "BYK-325", "BYK-330", "BYK-333", "BYK-337", "BYK-341", "BYK-344", "BYK-370", "BYK-375", "BYK-UV3500", "BYK-UV3510", "BYK-UV3570", "BYK-3550", "BYK-SILCLEAN3700", "BYK-SILCLEAN3720" (all of which is manufactured by BYK Japan K.K.), trade name "AC FS 180", "AC FS 360", "AC S 20" (all of which is manufactured by Algin-Chemie), trade name "POLYFLOW KL-400X", "POLYFLOW KL-400HF", "POLYFLOW KL-401", "POLYFLOW KL-402", "POLYFLOW KL-403", "POLYFLOW KL-404", "POLYFLOW KL-700" (all of which is manufactured by KYOEISHA CHEMICAL Co., LTD.), trade name "KP-301", "KP-306", "KP-109", "KP-310", "KP-310B", "KP-323", "KP-326", "KP-341", "KP-104", "KP-110", "KP-112", "KP-360A", "KP-361", "KP-354", "KP-357", "KP-358", "KP-359", "KP-362", "KP-365", "KP-366", "KP-368", "KP-330", "KP-650", "KP-651", "KP-390", "KP-391", "KP-392" (all of which is manufactured by Shin-Etsu Chemical Co., Ltd.), trade name "LP-7001", "LP-7002", "8032 ADDITIVE", "FZ-2110", "FZ-2105", "67 ADDITIVE", "8618 ADDITIVE", "3 ADDITIVE", "56 ADDITIVE" (all of which is manufactured by Dow Corning Toray Co., Ltd.), "TEGO WET 270" (manufactured by Evonik Degussa Japan Co., Ltd.), "NBX-15" (manufactured by NEOS COMPANY LTD.), and the like can also be used.

An addition amount of the peeling agent in the temporary adhesive layer is preferably 0.01% by mass to 5.0% by mass, and more preferably 0.1% by mass to 2.0% by mass.

The temporary adhesive layer may contain one kind of peeling agent, or two or more kinds thereof may be used in combination.

-Plasticizer-

The temporary adhesive layer may contain a plasticizer as necessary. As the plasticizer, phthalic acid ester, fatty acid ester, aromatic polycarboxylic acid ester, polyester, and the like can be used.

Examples of the phthalic acid ester include DMP, DEP, DBP, #10, BBP, DOP, DINP, DIDP (all of which is manufactured by DAIHACHI CHEMICAL INDUSTRY CO., LTD.), PL-200, DOIP (both of which is manufactured by CG ESTER CORPORATION), and SANSO CIZER DUP (manufactured by New Japan Chemical Co., Ltd.).

Examples of the fatty acid ester include butyl stearate, Unistar M-9676, Unistar M-2222SL, Unistar H-476, Unistar H-476D, Panacet 800B, Panacet 875, Panacet 810 (all of which is manufactured by NOF CORPORATION), DBA, DIBA, DBS, DOA, DINA, DIDA, DOS, BXA, DOZ, and DESU (all of which is manufactured by DAIHACHI CHEMICAL INDUSTRY CO., LTD.).

Examples of the aromatic polycarboxylic acid ester include TOTM and Monocizer W-705 (both of which is manufactured by DAIHACHI CHEMICAL INDUSTRY CO., LTD.), and UL-80 and UL-100 (both of which is manufactured by ADEKA CORPORATION).

Examples of the polyester include Polycizer TD-1720, Polycizer S-2002, Polycizer S-2010 (all of which is

manufactured by DIC Corporation), and BAA-15 (manufactured by DAIHACHI CHEMICAL INDUSTRY CO., LTD.).

Among the above-described plasticizers, DIDP, DIDA, TOTM, Unistar M-2222SL, or Polycizer TD-1720 is preferable, DIDA or TOTM is more preferable, and TOTM is particularly preferable. The plasticizer may be used singly or in combination of two or more kinds thereof.

In particular, since thermoplasticity of the cellulose acetate is relatively small, it is useful to add a plasticizer to the cellulose acetate. Examples of a preferred plasticizer for the cellulose acetate include triethyl citrate, triethyl acetyl citrate, dibutyl phthalate (DBP), diaryl phthalate, diethyl phthalate (DEP), dimethyl phthalate (DMP), di-2-methoxyethyl phthalate, dibutyl tartrate, ethyl o-benzoylbenzoate, ethylphthalyl ethylglycolate (EPEG), methylphthalyl ethylglycolate (MPEG), N-ethyl toluenesulfonamide, triacetin, O-cresyl p-toluenesulfonate, triethyl phosphate (TEP), triphenyl phosphate (TPP), and tripropionin.

From the viewpoint of preventing sublimation in a case of heating, in the plasticizer, a temperature at which, in a case where change in mass is measured under a nitrogen stream and a condition of heating at a constant rate of 20 °C/min, the mass of the plasticizer decreases by 1% by mass is preferably 250°C or higher, more preferably 270°C or higher, and particularly preferably 300°C or higher. The upper limit thereof is not particularly limited, and for example, may be 500°C or lower.

An addition amount of the plasticizer in the temporary adhesive layer is preferably 0.01% by mass to 5.0% by mass, and more preferably 0.1% by mass to 2.0% by mass.

-Antioxidant-

The temporary adhesive layer may contain an antioxidant. As the antioxidant, a phenol-based antioxidant, a sulfur-based antioxidant, a phosphorus-based antioxidant, a quinone-based antioxidant, an amine-based antioxidant, and the like can be used.

Examples of the phenol-based antioxidant include p-methoxyphenol, 2,6-di-tert-butyl-4-methylphenol, Irganox 1010, Irganox 1330, Irganox 3114, Irganox 1035 (all of which is manufactured by BASF Japan), Sumilizer MDP-S, and Sumilizer GA-80 (both of which is manufactured by Sumitomo Chemical Co., Ltd.).

Examples of the sulfur-based antioxidant include 3,3'-thiodipropionate distearyl, Sumilizer TPM, Sumilizer TPS, and Sumilizer TP-D (all of which is manufactured by Sumitomo Chemical Co., Ltd.).

Examples of the phosphorus-based antioxidant include tris(2,4-di-tert-butylphenyl) phosphite, bis(2,4-di-tert-butylphenyl) pentaerythritol diphosphite, poly(dipropylene glycol), phenyl phosphite, diphenyl isodecyl phosphite, 2-ethylhexyl diphenyl phosphite, triphenyl phosphite, Irgafos 168, and Irgafos 38 (both of which is manufactured by BASF Japan).

Examples of the quinone-based antioxidant include p-benzoquinone and 2-tert-butyl-1,4-benzoquinone.

Examples of the amine-based antioxidant include dimethylaniline and phenothiazine.

As the antioxidant, Irganox 1010, Irganox 1330, 3,3'-thiodipropionate distearyl, or Sumilizer TP-D is preferable, Irganox 1010 or Irganox 1330 is more preferable, and Irganox 1010 is particularly preferable.

In addition, among the above-described antioxidants, it is preferable to use a phenol-based antioxidant and a sulfur-based antioxidant or a phosphorus-based antioxidant in combination, and it is most preferable to use a phenol-based antioxidant and a sulfur-based antioxidant in combination. In particular, in a case where the polystyrene-based elastomer is used as the elastomer, it is preferable to use a phenol-based antioxidant and a sulfur-based antioxidant in combination. With such a combination, the effect of effectively suppressing the deterioration of the composition for forming a temporary adhesive layer due to an oxidation reaction can be expected. In a case of using a phenol-based antioxidant and a sulfur-based antioxidant in combination, a mass ratio of both is preferably phenol-based antioxidant:sulfur-based antioxidant = 95:5 to 5:95 and more preferably 25:75 to 75:25.

As the combination of the antioxidants, a combination of Irganox 1010 and Sumilizer TP-D, Irganox 1330 and Sumilizer TP-D, or Sumilizer GA-80 and Sumilizer TP-D is preferable, a combination of Irganox 1010 and Sumilizer TP-D, or Irganox 1330 and Sumilizer TP-D is more preferable, and a combination of Irganox 1010 and Sumilizer TP-D is particularly preferable.

From the viewpoint of preventing sublimation during heating, a molecular weight of the antioxidant is preferably 400 or more, more preferably 600 or more, and particularly preferably 750 or more.

In a case where the temporary adhesive layer contains an antioxidant, a content of the antioxidant in the temporary adhesive layer is preferably 0.001% to 20.0% by mass, and more preferably 0.005% to 10.0% by mass. The antioxidant may be used singly or in combination of two or more kinds thereof. In a case where two or more kinds of antioxidants are used, the total amount thereof is preferably within the above-described range.

-Other additives-

In the temporary adhesive layer used in the present invention, various additives such as a curing agent, a curing

catalyst, a filler, an adhesion promoter, an ultraviolet absorber, and an aggregation inhibitor can be blended in addition to the above-described additives, within a range in which the effects of the present invention is not impaired. In a case where these additives are blended, the total blending amount thereof is preferably 3% by mass or less of the temporary adhesive layer.

The temporary adhesive layer may be a monolayer structure or a multilayer structure. In a case of a multilayer structure, the temporary adhesive layer can include one or more resin layers consisting of each of the above-described resins. In addition, the temporary adhesive layer can also contains a peeling layer at an interface with the support or an interface with the base material. Examples of the peeling layer include a layer containing the above-described peeling agent, and a layer containing only the peeling agent can also be used.

A thickness of the temporary adhesive layer in the laminate is preferably 10 to 100 μm. In a case where the thickness of the temporary adhesive layer is within the above-described range, the thickness of the temporary adhesive layer is within an appropriate range on the base material peeled off from the support, and the function of the temporary adhesive layer as a protective film is exhibited more effectively. The upper limit of the numerical range is preferably 90 μm or less, more preferably 85 μm or less, and still more preferably 80 μm or less. In addition, the lower limit of the numerical range is preferably 15 μm or more, more preferably 20 μm or more, and still more preferably 30 μm or more.

<Flattening step>

The manufacturing method of a processed base material according to the embodiment of the present invention includes a step (flattening step) of flattening a surface of the temporary adhesive layer on a side opposite to a surface in contact with the base material or a surface of the temporary adhesive layer on a side opposite to a surface in contact with the support by at least one unit of polishing or grinding.

The polishing unit is not particularly limited and a known unit can be used, and examples thereof include a polishing pad, a polishing platen, and a polishing agent.

The grinding unit is not particularly limited and a known unit can be used, and examples thereof include a grinder.

A surface roughness Ra (arithmetic average roughness) of the flattened surface of the temporary adhesive layer after the flattening step is preferably 1.5 μm or less, more preferably 1.0 μm or less, still more preferably 0.8 μm or less, and particularly preferably 0.5 μm or less.

In addition, a surface roughness Ra (maximum roughness) of the surface of the temporary adhesive layer, which is to be flattened, before the flattening step is preferably 1 to 10 μm and more preferably 2 to 5 μm.

The above-described surface roughness Rz can be measured using a contact type surface roughness meter.

<Contacting step>

The manufacturing method of a processed base material according to the embodiment of the present invention includes a step (contacting step) of contacting the flattened surface of the temporary adhesive layer after the flattening with a member of the base material or the support, on which the temporary adhesive layer has not been formed.

The contacting step is preferably performed using, for example, a known pressuring device.

In the adhesion using the pressuring device, it is preferable to individually or simultaneously apply heat and press to the base material, the temporary adhesive layer, and the support, and it is more preferable to simultaneously apply both. A heating temperature is, for example, 50°C to 300°C, although it depends on the components contained in the composition for forming a temporary adhesive layer. The upper limit of the numerical range is preferably 250°C or lower and more preferably 200°C or lower. In addition, the lower limit of the numerical range is preferably 80°C or higher and more preferably 100°C or higher. A heating time is, for example, 30 seconds to 30 minutes. The upper limit of the numerical range is preferably 15 minutes or less and more preferably 5 minutes or less. In addition, the lower limit of the numerical range is preferably 45 seconds or more and more preferably 1 minute or more. A pressure is, for example, 0.05 to 3 $N/mm^2$. The upper limit of the numerical range is preferably 2.5 $N/mm^2$ or less and more preferably 2 $N/mm^2$ or less. In addition, the lower limit of the numerical range is preferably 0.08 $N/mm^2$ or more and more preferably 0.1 $N/mm^2$ or more. A pressure application time is, for example, 30 seconds to 30 minutes. The upper limit of the numerical range is preferably 20 minutes or less and more preferably 10 minutes or less. In addition, the lower limit of the numerical range is preferably 45 seconds or more and more preferably 1 minute or more.

<Base material processing step>

The manufacturing method of a processed base material according to the embodiment of the present invention includes a step (base material processing step) of processing a surface of the base material on a side opposite to a surface in contact with the temporary adhesive layer.

In the base material processing step, it is sufficient that a part of the surface of the above-described base

material on the side opposite to the surface in contact with the above-described temporary adhesive layer. In addition, it is also a preferred aspect of the present invention to process the entire surface of the above-described base material on the side opposite to the surface in contact with the above-described temporary adhesive layer.

The base material processing step is preferably a step of thinning the base material.

The thinning of the base material is not particularly limited and may be performed by a known method, and examples thereof include a method of performing grinding on the surface of the base material on the side opposite to the surface in contact with the temporary adhesive layer.

The above-described grinding is performed by, for example, a grinder.

<Peeling step>

It is preferable that the manufacturing method of a processed base material according to the embodiment of the present invention further includes a step (peeling step) of peeling off the base material and the support after the above-described step (base material processing step) of processing.

The peeling method is not particularly limited and a known method can be used, and examples thereof include a method of mechanically applying a force using a peeling device to perform peeling.

In addition, the peeling may be performed by a method of inserting a blade or the like into layers of the laminate (for example, between the support and the temporary adhesive layer, between the temporary adhesive layer and the base material, and the like) or an interlayer of the laminate (for example, in the temporary adhesive layer) and peeling off.

It is sufficient that the peeling step is a step of peeling off the base material and the support, and the temporary adhesive layer may be present on the surface of the support after the peeling, may be present on the surface of the base material after the peeling, or may be present on both the surface of the support and the surface of the base material after the peeling due to breakage of the temporary adhesive layer. However, from the viewpoint of usability of the support, it is preferable that the temporary adhesive layer is present on the surface of the base material after the peeling.

That is, the peeling step is preferably a step of peeling off the base material and the support at an interface between the support and the temporary adhesive layer.

For example, in the temporary adhesive layer forming step, by forming the temporary adhesive layer by applying the composition for forming a temporary adhesive layer, containing the peeling agent, onto the base material, it is possible to peel off at the interface between the temporary adhesive layer and the support.

In addition, by forming the above-described peeling layer on the interface side between the support and the temporary adhesive layer, it is also possible to peel off at the interface between the temporary adhesive layer and the support.

<Removal step>

It is preferable that the manufacturing method of a processed base material according to the embodiment of the present invention further includes a step (removal step) of removing the above-described temporary adhesive layer from the base material, and it is more preferable to further include a step of removing the above-described temporary adhesive layer from the base material by spray washing.

It is preferable that the removal step is performed after the above-described peeling step.

The removal of the temporary adhesive layer may be performed by physically peeling off the temporary adhesive layer manually or using a machine, but it is preferable to be performed by a method of supplying a solvent, such as a dipping method and a spray washing, and it is more preferable to be performed by spray washing.

The above-described solvent is preferably an organic solvent. As the organic solvent, the organic solvent described as the organic solvent used in the composition for forming a temporary adhesive layer can be used.

A temperature of the solvent in removing the temporary adhesive layer is, for example, 10° to 50°C. The upper limit of the numerical range is preferably 45°C or lower and more preferably 40°C or lower. In addition, the lower limit of the numerical range is preferably 15°C or higher and more preferably 20°C or higher. In addition, an ultrasonic washing may be performed by irradiating an ultrasonic wave (approximately 20 to 50 kHz) in combination with the application of the organic solvent.

<Other steps>

The manufacturing method of a processed base material according to the embodiment of the present invention may further include other steps.

Examples of the other steps include a base material dividing step.

[Base material dividing step]

It is preferable that the manufacturing method of a processed base material according to the embodiment of the present invention includes a step (base material dividing step) of dividing the base material.
The step of dividing the base material may be performed before the base material processing step, but is preferably performed after the base material processing step and more preferably performed after the base material processing step and before the peeling step.
Examples of the base material dividing step include a known dicing step.
The dicing method is not particularly limited, and is appropriately selected such as blade dicing, laser dicing, and plasma dicing. An aspect of cutting is not particularly limited, and may be either half-cut or full-cut, and among the full-cut, a single cut, a step cut, or a bevel cut may be used.
A depth of cutting is appropriately adjusted according to the thicknesses of the temporary adhesive layer and the base material, and is preferably, for example, 50% or more of the total thickness of the temporary adhesive layer and the base material. In a case where the cutting does not reach the bonding interface between the temporary adhesive layer and the support, the dividing of the base material can also be facilitated by expanding the support.
The depth of cutting is more preferably 70% or more and still more preferably 80% or more of the above-described total thickness. In addition, the depth of cutting may be 100% of the total thickness (that is, the cutting reaches the bonding interface between the temporary adhesive layer and the support), or may be 90% or less of the total thickness. The depth of cutting may reach the inside of the support within a range that does not hinder the dicing treatment, but from the viewpoint of stability of the dicing treatment, it is preferable that the depth of cutting does not reach the inside of the support. A width of cutting can be appropriately adjusted, and is, for example, 0.01 to 1 mm. The upper limit of the numerical range is preferably 0.5 mm or less and more preferably 0.3 mm or less. In addition, the lower limit of the numerical range is preferably 0.03 mm or more and more preferably 0.05 mm or more.
A shape of the divided base material (chip) is preferably a rectangular shape except for the outer region of the base material, but may be other polygonal shapes. A size (length of the maximum side) of the chip is not particularly limited, and is, for example, 0.8 to 3 mm. The upper limit of the numerical range may be 2.5 mm or less or 2 mm or less. In addition, the lower limit of the numerical range may be 0.9 mm or more or 1 mm or more.

<Composition for forming temporary adhesive layer>

The composition for forming a temporary adhesive layer according to the present invention contains an inorganic filler.
In addition, the composition for forming a temporary adhesive layer according to the present invention is a composition used for forming a temporary adhesive layer, and is preferably used for forming the temporary adhesive layer in the manufacturing method of a processed base material according to the embodiment of the present invention.
The composition for forming a temporary adhesive layer contains material components of the above-described temporary adhesive layer as a solid content, and can contain a solvent as necessary.
The solvent used in the above-described composition for forming a temporary adhesive layer is preferably an organic solvent.
Suitable examples of the organic solvent include esters such as ethyl acetate, n-butyl acetate, isobutyl acetate, amyl formate, isoamyl acetate, butyl propionate, isopropyl butyrate, ethyl butyrate, butyl butyrate, methyl lactate, ethyl lactate, alkyl alkyloxyacetates (for example, methyl alkyloxyacetate, ethyl alkyloxyacetate, and butyl alkyloxyacetate (for example, methyl methoxyacetate, ethyl methoxyacetate, butyl methoxyacetate, methyl ethoxyacetate, and ethyl ethoxyacetate)), alkyl 3-alkyloxypropionate esters (for example, methyl 3-alkyloxypropionate and ethyl 3-alkyloxypropionate (for example, methyl 3-methoxypropionate, ethyl 3-methoxypropionate, methyl 3-ethoxypropionate, and ethyl 3-ethoxypropionate)), alkyl 2-alkyloxypropionate esters (for example, methyl 2-alkyloxypropionate, ethyl 2-alkyloxypropionate, and propyl 2-alkyloxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-alkyloxy-2-methyl propionate and ethyl 2-oxy-2-methyl propionate (for example, methyl 2-methoxy-2-methyl propionate and ethyl 2-ethoxy-2-methyl propionate), methyl pyruvate, ethyl pyruvate, propyl pyruvate, methyl acetoacetate, ethyl acetoacetate, methyl 2-oxobutanoate, ethyl 2-oxobutanoate, and 1-methoxy-2-propyl acetate;

ethers such as diethylene glycol dimethyl ether, tetrahydrofuran, ethylene glycol monomethyl ether, ethylene glycol monoethyl ether, methyl cellosolve acetate, ethyl cellosolve acetate, diethylene glycol monomethyl ether, diethylene glycol monoethyl ether, diethylene glycol monobutyl ether, propylene glycol monomethyl ether, propylene glycol monomethyl ether acetate, propylene glycol monoethyl ether acetate, and propylene glycol monopropyl ether acetate;
ketones such methyl ethyl ketone, cyclohexanone, 2-heptanone, 3-heptanone, N-methyl-2-pyrrolidone, and γ-butyrolactone;

aromatic hydrocarbons such as toluene, xylene, anisole, mesitylene, ethylbenzene, propylbenzene, cumene, n-butylbenzene, sec-butylbenzene, isobutylbenzene, t-butylbenzene, amylbenzene, isoamylbenzene, (2,2-dimethylpropyl) benzene, 1-phenylhexane, 1-phenylheptane, 1-phenyloctane, 1-phenylnonane, 1-phenyldecane, cyclopropylbenzene, cyclohexylbenzene, 2-ethyltoluene, 1,2-diethylbenzene, o-cymene, indane, 1,2,3,4-tetrahydronaphthalene, 3-ethyltoluene, m-cymene, 1,3-diisopropylbenzene, 4-ethyltoluene, 1,4-diethylbenzene, p-cymene, 1,4-diisopropylbenzene, 4-t-butyltoluene, 1,4-di-t-butylbenzene, 1,3-diethylbenzene, 1,2,3-trimethylbenzene, 1,2,4-trimethylbenzene, 4-t-butyl-o-xylene, 1,2,4-triethylbenzene, 1,3,5-triethylbenzene, 1,3,5-triisopropylbenzene, 5-t-butyl-m-xylene, 3,5-di-t-butyltoluene, 1,2,3,5-tetramethylbenzene, 1,2,4,5-tetramethylbenzene, and pentamethylbenzene; and

hydrocarbons such as limonene, p-menthane, nonane, decane, dodecane, and decalin.

Among these, mesitylene, t-butylbenzene, 1,2,4-trimethylbenzene, p-menthane, γ-butyrolactone, anisole, methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, ethyl carbitol acetate, butyl carbitol acetate, propylene glycol methyl ether, or propylene glycol methyl ether acetate is preferable.

From the viewpoint of improving properties of a coated surface or the like, it is also preferable to mix two or more kinds of these solvents. In this case, a mixed solution composed of two or more kinds selected from mesitylene, t-butylbenzene, 1,2,4-trimethylbenzene, p-menthane, γ-butyrolactone, anisole, methyl 3-ethoxypropionate, ethyl 3-ethoxypropionate, ethyl cellosolve acetate, ethyl lactate, diethylene glycol dimethyl ether, butyl acetate, methyl 3-methoxypropionate, 2-heptanone, cyclohexanone, cyclopentanone, ethyl carbitol acetate, butyl carbitol acetate, propylene glycol methyl ether, and propylene glycol methyl ether acetate is particularly preferable.

From the viewpoint of coating property, a content of the solvent contained in the composition for forming a temporary adhesive layer is such that the total concentration of solid contents of the composition is preferably 5% to 80% by mass, more preferably 10% to 50% by mass, and particularly preferably 12% to 40% by mass. The solvent may be used singly or in combination of two or more kinds thereof. In a case where two or more kinds of solvents are used, the total amount thereof is preferably within the above-described range.

The content of the solvent in the temporary adhesive layer obtained by drying is preferably 1% by mass or less, and more preferably 0.1% by mass or less.

<Manufacturing method of semiconductor element>

The manufacturing method of a semiconductor element according to the embodiment of the present invention includes the above-described manufacturing method of a processed base material.

The semiconductor element manufactured by the manufacturing method according to the embodiment of the present invention is, for example, an LSI device, but the semiconductor element according to the present invention is not limited thereto, and the present invention can be applied to various semiconductor elements.

The present invention can also be applied to, for example, logic integrated circuits such as an application specific integrated circuit (ASIC), a field programmable gate array (FPGA), and an application specific standard product (ASSP). In addition, the present invention can also be applied to, for example, microprocessors such as a central processing unit (CPU) and a graphics processing unit (GPU). In addition, the present invention can also be applied to, for example, memories such as a dynamic random access memory (DRAM), a hybrid memory cube (HMC), a magnetoresistive random access memory (MRAM), a phase-change memory (PCM), a resistance random access memory (ReRAM), a ferroelectric random access memory (FeRAM), and a flash memory. In addition, the present invention can also be applied to, for example, analog integrated circuits such as a light emitting diode (LED), a power device, a direct current (DC)-direct current (DC) connector, and an insulated gate bipolar transistor (IGBT). In addition, the present invention can also be applied to, for example, micro electro mechanical systems (MEMS) such as an acceleration sensor, a pressure sensor, a vibrator, and a gyro sensor. In addition, the present invention can also be applied to, for example, wireless elements such as a global positioning system (GPS), frequency modulation (FM), near field communication (NFC), a RF expansion module (RFEM), a monolithic microwave integrated circuit (MMIC), and a wireless local area network (WLAN); discrete elements, complementary metal oxide semiconductors (CMOS), CMOS image sensors, camera modules, passive devices, surface acoustic wave (SAW) filters, radio frequency (RF) filters, and integrated passive devices (IPD).

A final product on which the above-described semiconductor element according to the present invention is mounted is not particularly limited, and examples thereof include a smart TV, a mobile communication terminal, a mobile phone, a smartphone, a tablet terminal, a desktop PC, a notebook PC, network equipment (such as a router and a switching instrument), wired infrastructure equipment, a digital camera, a game console, a controller, a data center, a server, a mining PC, an HPC, a graphic card, a network server, a storage, a chip set, an in-vehicle apparatus (such as

an electronic control unit and a driving support system), a car navigation system, a PND, an illumination (such as a general illumination, an in-vehicle illumination, an LED illumination, and an OLED illumination), a television, a display, a display panel (such as a liquid crystal panel, an organic EL panel, and an electronic paper), a music player terminal, industrial equipment, an industrial robot, an inspecting apparatus, a medical device, white goods, space and aircraft equipment, and a wearable device.

Examples

Hereinafter, the present invention will be described in more detail with reference to Examples. The materials, the used amounts, the proportions, the treatment details, the treatment procedures, and the like shown in the following Examples can be appropriately modified without departing from the spirit of the present invention. Therefore, the scope of the present invention is not limited to the specific examples described below. Unless otherwise specified, "part" and "%" are based on mass.

<Formation of base material on which temporary adhesive layer is formed>

In each of Examples and Comparative Examples, components described in the column of "Composition for forming temporary adhesive layer or comparative composition" in the table below were dissolved or mixed in cyclopentanone such that a content proportion of each component was a proportion described in the column of "% by mass" in the table below, thereby preparing a composition for forming a temporary adhesive layer or a comparative composition. The concentration of solid contents in the composition was set to be 14% by mass. In the table below, the description of "-" indicates that the corresponding component was not contained.

The composition for forming a temporary adhesive layer or the comparative composition was applied to a base material or a support, the base material being a base material which had a height described in the column of "Base material step (μm)" of the table, had a square shape with a side of 100 μm, had a smooth surface in which steps were aligned at intervals of 1 mm in length and width, and was a disk-shaped silicon wafer having a diameter of 300 mm and a thickness of 750 μm. In the above-described operation, the composition for forming a temporary adhesive layer or the comparative composition was applied to the base material in an example in which the column of "Coating surface" in the table is described as "A", and was applied to the support in an example of being described as "B". This was heated and dried at the temperature described in the column of " 1st stage" in the table for 5 minutes, and then further heated and dried at the temperature °C described in the column of "2nd stage" in the table for 3 minutes, thereby forming a temporary adhesive layer on the base material. As a coating method, a spin coating method was used in an example in which the column of "Coating method" in the table is described as "A", a slit coating method was used in an example in which the column of "Coating method" in the table is described as "B", and a spiral coating method was used in an example in which the column of "Coating method" in the table is described as "C".

By the same method, five base materials on which the temporary adhesive layer was formed were produced in each of Examples and Comparative Examples.

In the table, the description in the column of "% by volume" of "Temporary adhesive layer" indicates the content (% by mass) of the inorganic filler with respect to the total volume of the temporary adhesive layer.

«Flattening of temporary adhesive layer (evaluation of peeling)»

With regard to an example in which "Grinding" is described in the column of "Flattening method" in the table, in the five base materials on which the temporary adhesive layer was formed, the surface of the base material on which the temporary adhesive layer was formed on the side opposite to the surface in contact with the base material was ground and flattened with a #2000 grinder. For the above-described flattening, five sheets were continuously produced using the same grinder without performing a treatment such as sharpening of the grinder in the middle. Whether or not a problem such as peeling of the base material and the temporary adhesive layer or breakage of the base material occurred during the process was confirmed on the five base materials on which the temporary adhesive layer was formed.

With regard to an example in which "Polishing" is described in the column of "Flattening method" in the table, in the five base materials on which the temporary adhesive layer was formed, the surface of the base material on which the temporary adhesive layer was formed on the side opposite to the surface in contact with the base material was flattened by polishing with a polishing pad and polishing slurry. As the polishing pad, a polishing pad made of polyurethane, having a surface roughness (Ra) = 0.8 μm, was used, and as the polishing slurry, a slurry containing 2% by mass of silica particles having a volume average particle size of 60 nm was used. Five sheets were continuously produced using the same polishing pad without performing a treatment such as sharpening of the grinder in the middle. Whether or not a problem such as peeling of the base material and the temporary adhesive layer or breakage of the base material occurred during the process was confirmed on the five base materials on which the temporary adhesive layer was formed.

Each evaluation was performed according to the following evaluation standard, and the evaluation results are described in the column of "Peeling evaluation" in the table.

-Evaluation standard-

A: no peeling was observed in any of the five sheets.
B: peeling having a size of less than 1 $mm^2$ was observed in one or more of the five sheets, but no peeling having a size of more than 1 $mm^2$ was observed in any of the five sheets.
C: peeling of 1 $mm^2$ or more was observed in one or more of the five sheets.

<Production of laminate>

Five base materials on which the polished or ground temporary adhesive layer obtained by the method described in "Flattening of laminate" was formed were prepared for each of Examples and Comparative Examples.
The surface of the temporary adhesive layer on the base material on which the above-described polished or ground temporary adhesive layer was formed, opposite to the surface in contact with the base material (polished or ground surface) was pressed against the support described in the table at a pressure of 0.1 $N/mm^2$, thereby producing a laminate including the base material, the temporary adhesive layer, and the support in this order.
Details of the support listed in the table are as follows.

· S-1: UC-334EP-85 (manufactured by FURUKAWA ELECTRIC CO., LTD.)
· S-2: UC-3026M-110 (manufactured by FURUKAWA ELECTRIC CO., LTD.)
· S-3: UC-3044M-110B (manufactured by FURUKAWA ELECTRIC CO., LTD.)
· S-4: UC-353EP-110A (manufactured by FURUKAWA ELECTRIC CO., LTD.)

<<Back-grinding of laminate (evaluation of workability of base material)>>

In each of Examples and Comparative Examples, the surface of the base material included in each of the five laminates, on the side in contact with the temporary adhesive layer, was ground with a #2000 grinder to reduce a thickness of the base material to 100 μm. Whether or not breakage of the base material in the laminate occurred during the process was confirmed for all five laminates.
Each evaluation was performed according to the following evaluation standard, and the evaluation results are described in the column of "Peeling evaluation" in the table.

-Evaluation standard-

A: no breakage was confirmed in any of the five sheets.
B: chipping (breakage of 1 mm or less) occurred in a part of one of the five sheets.
C: chipping occurred in two or more of the five sheets, or breakage of 1 mm or more occurred in one or more of the five sheets.

[Table 1]

| | | Composition for forming temporary adhesive layer or comparative composition | | | | | | | | Temporary Adhesive layer | Coating method | Coating surface | Drying temperature (°C) | | Base material | Support | Evaluation | | |
|---|---|---|---|---|---|---|---|---|---|---|---|---|---|---|---|---|---|---|---|
| | | Resin 1 | % by mass | Resin 2 | % by mass | Inorganic filler | % by mass | Peeling agent | % by mass | % by mass | | | 1st stage | 2nd stage | Base material step (μm) | | Peeling evaluation | Workability | Flattening method |
| Example | 1 | P-1 | 9.9 | - | - | F-1 | 90.0 | R-1 | 0.1 | 81.8 | A | A | 100 | 150 | 0.1 | S-1 | B | A | Grinding |
| | 2 | P-2 | 15.0 | - | - | F-2 | 85.0 | - | - | 73.9 | A | A | 80 | 150 | 1 | S-2 | A | A | Grinding |
| | 3 | P-3 | 200 | - | - | F-3 | 80.0 | - | - | 66.7 | A | A | 80 | 150 | 2 | S-3 | A | A | Grinding |
| | 4 | P-4 | 25.0 | - | - | F-4 | 75.0 | - | - | 60.0 | A | A | 80 | 150 | 5 | S-4 | A | A | Grinding |
| | 5 | P-5 | 30.0 | - | - | F-5 | 70.0 | - | - | 538 | A | A | 80 | 150 | 10 | S-1 | B | A | Grinding |
| | 6 | P-6 | 35.0 | - | - | F-6 | 65.0 | - | - | 48.1 | A | A | 80 | 150 | 8 | S-2 | A | A | Grinding |
| | 7 | P-7 | 39.8 | - | - | F-7 | 60.0 | R-2 | 02 | 429 | A | A | 80 | 150 | 3 | S-3 | A | A | Polishing |
| | 8 | P-8 | 450 | - | - | F-8 | 55.0 | - | - | 37.4 | A | A | 80 | 150 | 0.5 | S4 | A | A | Polishing |
| | 9 | P-9 | 50.0 | - | - | F-1 | 500 | - | - | 33.3 | A | A | 80 | 150 | 2 | S-1 | A | A | Polishing |
| | 10 | P-10 | 550 | - | - | F-2 | 45.0 | - | - | 29.0 | A | A | 80 | 150 | 4 | S-2 | A | B | Polishing |
| | 11 | P-11 | 60.0 | - | - | F-3 | 40.0 | - | - | 25.0 | A | A | 80 | 150 | 1 | S-3 | B | B | Polishing |
| | 12 | P-12 | 61.9 | - | - | F-4 | 35.0 | R-3 | 0.1 | 21.2 | A | A | 80 | 150 | 3 | S-4 | A | B | Grinding |
| | 13 | P-1 | 650 | - | - | F-5 | 35.0 | - | - | 21.2 | A | A | 80 | 150 | 7 | S-1 | A | B | Grinding |
| | 14 | P-2 | 32.5 | P-3 | 32 5 | F-6 | 35.0 | - | - | 212 | A | A | 80 | 150 | 0.6 | S-2 | A | B | Grinding |
| | 15 | P-3 | 30.0 | P-4 | 300 | F-7 | 400 | - | - | 25.0 | A | A | 80 | 150 | 0.2 | S-3 | A | B | Grinding |
| | 16 | P-4 | 274 | P-5 | 27.6 | F-8 | 45.0 | R-4 | 0.2 | 290 | A | A | 80 | 150 | 8 | S-4 | A | B | Grinding |
| | 17 | P-5 | 25.0 | P-6 | 25.0 | F-1 | 50.0 | - | - | 33.3 | A | A | 80 | 150 | 0.4 | S-1 | A | B | Grinding |
| | 18 | P-6 | 22.5 | P-7 | 22.5 | F-2 | 55.0 | - | - | 37.9 | A | A | 80 | 150 | 9 | S-2 | B | A | Grinding |
| | 19 | P-7 | 200 | P-8 | 20.0 | F-3 | 60.0 | - | - | 42.9 | A | A | 80 | 150 | 0.3 | S-3 | A | A | Grinding |
| | 20 | P-8 | 17.5 | P-9 | 17.5 | F-4 | 65.0 | - | - | 48.1 | A | A | 80 | 150 | 11 | S-4 | B | A | Grinding |
| | 21 | P-9 | 150 | P-10 | 15.0 | F-5 | 70.0 | - | - | 53.8 | A | A | 80 | 150 | 6 | S-1 | A | A | Grinding |

(continued)

| | | Composition for forming temporary adhesive layer or comparative composition | | | | | | | | Temporary Adhesive layer | Coating method | Coating surface | Drying temperature (°C) | | Base material | Support | Evaluation | | |
|---|---|---|---|---|---|---|---|---|---|---|---|---|---|---|---|---|---|---|---|
| | | Resin 1 | % by mass | Resin 2 | % by mass | Inorganic filler | % by mass | Peeling agent | % by mass | % by mass | | | 1st stage | 2nd stage | Base material step (μm) | | Peeling evaluation | Workability | Flattening method |
| | 22 | P-10 | 12.5 | P-11 | 125 | F-6 | 75.0 | - | - | 60.0 | B | A | 80 | 150 | 3 | S-2 | A | A | Grinding |
| | 23 | P-11 | 10.0 | P-12 | 10.0 | F-7 | 80.0 | - | - | 66.7 | C | A | 80 | 150 | 1 | S-3 | A | A | Grinding |
| | 24 | P-1 | 9.9 | - | - | F-1 | 90.0 | R-1 | 0.1 | 81.8 | A | B | 80 | 150 | 0.1 | S-4 | B | B | Grinding |
| | 25 | P-2 | 150 | - | - | F-2 | 85.0 | - | - | 73.9 | A | A | 130 | 130 | 1 | S-1 | A | B | Grinding |
| Comparative Example | 1 | P-11 | 100.0 | - | - | - | - | - | - | Not measured | A | A | 80 | 150 | 1 | S-2 | C | C | Polishing |
| | 2 | P-11 | 60.0 | - | - | F-3 | 40.0 | - | - | Not measured | A | A | 80 | 150 | 1 | S-3 | C | C | Not flattened |

Details of each of the materials listed in the above table are shown below.

<<Resin (resin 1 or resin 2)»

- P-1: styrene-based elastomer, SEPTON 4033 (manufactured by KURARAY CO., LTD.)
- P-2: polyvinyl acetoacetal, BL-7 (manufactured by SEKISUI CHEMICAL CO., LTD.)
- P-3: polyvinyl butyral, KS-6Z (manufactured by SEKISUI CHEMICAL CO., LTD.)
- P-4: polyvinyl butyral, B75H (manufactured by KURARAY CO., LTD.)
- P-5: polymethyl methacrylate, Delpet 80NH (manufactured by Asahi Kasei Corporation)
- P-6: cellulose acetate, L-20 (manufactured by Daicel Corporation)
- P-7: polyvinyl butyral, KS-5Z (manufactured by SEKISUI CHEMICAL CO., LTD.)
- P-8: polyvinyl butyral, BX-1 (manufactured by SEKISUI CHEMICAL CO., LTD.)
- P-9: cellulose acetate, LT-35 (manufactured by Daicel Corporation)
- P-10: cellulose acetate butyrate, CAB-381-20 (manufactured by TOMOE Engineering Co., Ltd.)
- P-11: polymethyl methacrylate, Bimodal 80NEN (manufactured by Asahi Kasei Corporation)
- P-12: styrene-butadiene-styrene block copolymer, TR2000 (JSR)

<<Inorganic filler>>

- F-1: silica particles, SO-C1 (manufactured by Admatechs.)
- F-2: silica particles, SO-C2 (manufactured by Admatechs.)
- F-3: silica particles, SO-C4 (manufactured by Admatechs.)
- F-4: alumina particles, AO-502 (manufactured by Admatechs.)
- F-5: silica particles, Seahostar KE-P30 (manufactured by NIPPON SHOKUBAI CO., LTD.)
- F-6: silica particles, Seahostar KE-P50 (manufactured by NIPPON SHOKUBAI CO., LTD.)
- F-7: alumina particles, AA-04 (manufactured by Sumitomo Chemical Co., Ltd.)
- F-8: alumina particles, AA-07 (manufactured by Sumitomo Chemical Co., Ltd.)

<<Peeling agent>>

- R-1: ADVALON FA33 (manufactured by Wacker AsahiKasei Silicone Co., Ltd.)
- R-2: KF-6013 (manufactured by Shin-Etsu Chemical Co., Ltd.)
- R-3: FZ-2191 (manufactured by Dow Corning Toray Co., Ltd.)
- R-4: MEGAFACE F-142D (manufactured by DIC Corporation)

From the results shown in the table, it is found that the manufacturing method of a processed base material according to the embodiment of the present invention is excellent in workability of the base material.

The comparative composition according to Comparative Example 1 does not contain an inorganic filler. It is found that, in a case where such a comparative composition is used, breakage occurs in the base material.

In addition, in the manufacturing method according to Comparative Example 2, the temporary adhesive layer is not flattened. It is found that, according to such a manufacturing method, breakage occurs in the base material.

In addition, a laminate including a silicon substrate having a thickness of 100 $\mu$m, the temporary adhesive layer, and the support in this order was obtained by the same method as the method described in "Back-grinding of laminate" in Examples 1 to 23, except that the base materials of Examples 1 to 23 were changed to a silicon substrate having a diameter of 300 mm and a thickness of 750 $\mu$m, on which a semiconductor circuit was formed. In this case, the surface of the silicon substrate on which the semiconductor circuit was formed was adhered to the temporary adhesive layer. An unevenness having a height difference of 0.5 $\mu$m was formed on the above-described surface on which the semiconductor circuit was formed.

Using a dicing device (DAD324, manufactured by DISCO Corporation), dicing was carried out by forming a single cut of 0.75 mm in depth with a pitch of 3 mm in longitudinal and lateral directions in the above-described laminate before the cut formation. As a result, a laminate with a cutting divided into 3 mm squares was obtained.

The laminate with a cutting was expanded, and a silicon substrate with a temporary adhesive layer cut into 3

mm squares was taken out from the laminate. The above-described silicon substrate with a temporary adhesive layer was peeled off at an interface between the support and the temporary adhesive layer.

The above-described silicon substrate with a temporary adhesive layer was spray-washed to remove the temporary adhesive layer from the silicon substrate.

Thereafter, the silicon substrate was packaged as a semiconductor element. The semiconductor element had no problem in performance.

Explanation of References

10: base material
12: temporary adhesive layer
14: support

**Claims**

1. A manufacturing method of a processed base material, comprising:

    a step of forming a temporary adhesive layer by applying a composition for forming a temporary adhesive layer onto a surface of one member of a base material or a support;
    a step of flattening a surface of the temporary adhesive layer on a side opposite to a surface in contact with the base material or a surface of the temporary adhesive layer on a side opposite to a surface in contact with the support by at least one unit of polishing or grinding;
    a step of contacting the flattened surface of the temporary adhesive layer after the flattening with a member of the base material or the support, on which the temporary adhesive layer has not been formed; and
    a step of processing a surface of the base material on a side opposite to a surface in contact with the temporary adhesive layer,
    wherein the temporary adhesive layer contains an inorganic filler.

2. The manufacturing method of a processed base material according to claim 1,
wherein the inorganic filler includes silica or alumina.

3. The manufacturing method of a processed base material according to claim 1 or 2,
wherein a content of the inorganic filler is 20% by volume or more with respect to a total volume of the temporary adhesive layer.

4. The manufacturing method of a processed base material according to any one of claims 1 to 3,
wherein, in the step of forming the temporary adhesive layer, the surface to which the composition for forming a temporary adhesive layer is applied has an unevenness with a height difference of 1 μm or more.

5. The manufacturing method of a processed base material according to any one of claims 1 to 4,
wherein, in the step of forming the temporary adhesive layer, a method for applying the composition for forming a temporary adhesive layer is any one of spin coating, slit coating, or spiral coating.

6. The manufacturing method of a processed base material according to any one of claims 1 to 5,
wherein the step of forming the temporary adhesive layer is a step of forming the temporary adhesive layer by drying the composition for forming a temporary adhesive layer while changing a temperature by 30°C or higher, after applying the composition for forming a temporary adhesive layer.

7. The manufacturing method of a processed base material according to any one of claims 1 to 6, further comprising:
a step of peeling off the base material and the support after the processing step.

8. The manufacturing method of a processed base material according to claim 7,
wherein the peeling step is a step of peeling off the base material and the support at an interface between the support and the temporary adhesive layer.

**9.** The manufacturing method of a processed base material according to any one of claims 1 to 8, further comprising: a step of removing the temporary adhesive layer from the base material by spray washing.

**10.** The manufacturing method of a processed base material according to any one of claims 1 to 9, wherein the support is in a form of a sheet or a film.

**11.** A manufacturing method of a semiconductor element, comprising: the manufacturing method of a processed base material according to any one of claims 1 to 10.

**12.** A composition for forming a temporary adhesive layer, which is used for forming the temporary adhesive layer according to any one of claims 1 to 10.

FIG. 1A

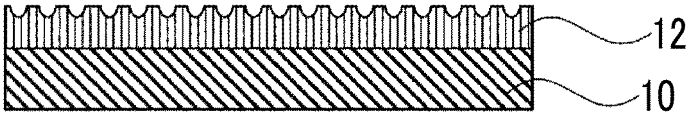


FIG. 1B

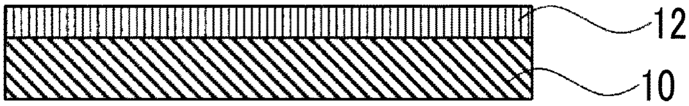


FIG. 1C

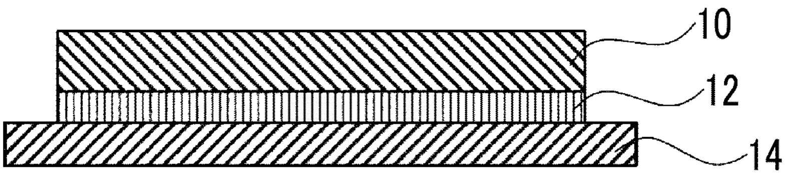


FIG. 1D

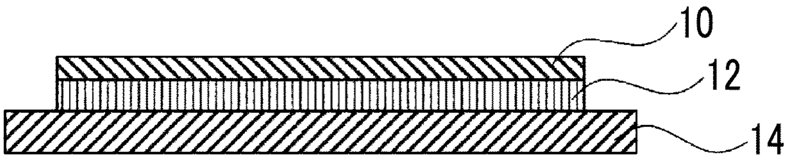


FIG. 1E

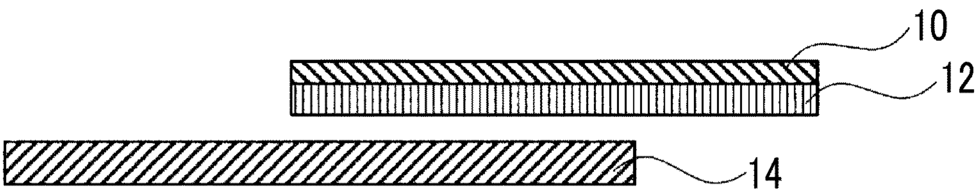


FIG. 1F

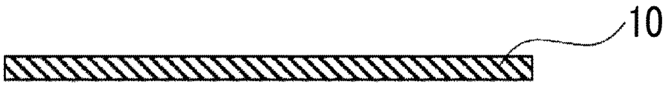

## INTERNATIONAL SEARCH REPORT

International application No.
**PCT/JP2021/031454**

**A. CLASSIFICATION OF SUBJECT MATTER**

***B24B 7/04***(2006.01)i; ***B23Q 3/08***(2006.01)i; ***B24B 37/04***(2012.01)i; ***B24B 41/06***(2012.01)i; ***H01L 21/304***(2006.01)i
FI: H01L21/304 631; B24B37/04; B24B7/04 A; B24B41/06 L; B23Q3/08 Z; H01L21/304 622J

According to International Patent Classification (IPC) or to both national classification and IPC

**B. FIELDS SEARCHED**

Minimum documentation searched (classification system followed by classification symbols)

B24B7/04; B23Q3/08; B24B37/04; B24B41/06; H01L21/304

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2018-49973 A (OKAMOTO MACHINE TOOL WORKS) 29 March 2018 (2018-03-29) paragraphs [0022]-[0081], fig. 1-6 | 1-12 |
| Y | JP 2009-45728 A (FUJITSU LTD) 05 March 2009 (2009-03-05) paragraphs [0017]-[0154], fig. 1-14 | 1-12 |
| Y | JP 2015-5636 A (NITTO DENKO CORP) 08 January 2015 (2015-01-08) paragraphs [0014]-[0119], fig. 1-5 | 1-12 |
| A | JP 2017-103441 A (OKAMOTO MACHINE TOOL WORKS) 08 June 2017 (2017-06-08) entire text, all drawings | 1-12 |
| A | JP 2013-084770 A (DISCO ABRASIVE SYSTEMS LTD) 09 May 2013 (2013-05-09) entire text, all drawings | 1-12 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **15 October 2021** | **09 November 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2021/031454**

| Patent document cited in search report | Publication date (day/month/year) | Patent family member(s) | Publication date (day/month/year) |
|---|---|---|---|
| JP 2018-49973 A | 29 March 2018 | CN 107866724 A<br>KR 10-2018-0033088 A<br>TW 201814847 A | |
| JP 2009-45728 A | 05 March 2009 | (Family: none) | |
| JP 2015-5636 A | 08 January 2015 | CN 104212369 A<br>KR 10-2014-0142675 A<br>TW 201506116 A | |
| JP 2017-103441 A | 08 June 2017 | (Family: none) | |
| JP 2013-084770 A | 09 May 2013 | CN 103042449 A<br>KR 10-2013-0039308 A<br>TW 201320175 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2017103441 A
- JP 2012174956 A
- JP 2010251722 A
- JP 2018037558 A
- JP 62036663 A
- JP S62036663 A
- JP 61226746 A
- JP S61226746 A
- JP 61226745 A
- JP S61226745 A
- JP 62170950 A
- JP S62170950 A
- JP 63034540 A
- JP S63034540 A
- JP 7230165 A
- JP H07230165 A
- JP 8062834 A
- JP H08062834 A
- JP 9054432 A
- JP H09054432 A
- JP 9005988 A
- JP H09005988 A
- JP 2001330953 A